## Europäisches Patentamt
## European Patent Office
## Office européen des brevets

(19)

(11) Veröffentlichungsnummer: **0 005 723**
**B1**

(12) **EUROPÄISCHE PATENTSCHRIFT**

(45) Veröffentlichungstag der Patentschrift: **09.06.82**

(21) Anmeldenummer: **79101237.0**

(22) Anmeldetag: **24.04.79**

(51) Int. Cl.³: **H 01 L 27/02, H 01 L 23/52**

(54) Hochintegrierte Halbleiterschaltung und Verfahren zu ihrer Herstellung.

(30) Priorität: **25.05.78 US 909605**

(43) Veröffentlichungstag der Anmeldung:
**12.12.79 Patentblatt 79/25**

(45) Bekanntmachung des Hinweises auf die Patenterteilung:
**09.06.82 Patentblatt 82/23**

(84) Benannte Vertragsstaaten:
**DE FR GB**

(56) Entgegenhaltungen:
EP - A - 0 001 209
FR - A - 2 365 883
US - A - 3 999 214
US - A - 4 032 962

PATENT ABSTRACTS OF JAPAN, Band 1, Nr. 19, 24. März 1977, Seite 612 E76

IBM TECHNICAL DISCLOSURE BULLETIN, Band 20, Nr. 8, Januar 1978
New York, U.S.A.
B.C. FOX et al.: "Large-scale integration modeling technique", Seiten 3129—3130

(73) Patentinhaber: **International Business Machines Corporation**
**Armonk, N.Y. 10504 (US)**

(72) Erfinder: **Balyoz, John**
**Deerwood Drive Box 247, RD 3**
**Hopewell Junction 12533 New York (US)**
Erfinder: **Chang, Chi Shih**
**14 Shale Drive**
**Wappingers Falls New York 12590 (US)**
Erfinder: **Fox, Barry Charles**
**26 Miron Drive**
**Poughkeepsie New York 12603 (US)**
Erfinder: **Ghafghaichi, Majid**
**352 Vassar Road**
**Poughkeepsie New York 12603 (US)**
Erfinder: **Jen, Teh-Sen**
**66 Star Mill Road**
**Fishkill New York 12524 (US)**
Erfinder: **Mooney, Donald Blaise**
**26 Hagan Drive**
**Poughkeepsie New York 12603 (US)**
Erfinder: **Palmieri, John Aldo**
**10 Montfort Woods Road**
**Wappingers Falls New York 12590 (US)**

(74) Vertreter: **Gaugel, Heinz, Dipl.-Ing.**
**Schönaicher Strasse 220**
**D-7030 Böblingen (DE)**

Courier Press, Leamington Spa, England.

Hochintegrierte Halbleiterschaltung und Verfahren zu ihrer Herstellung

Die Erfindung betrifft hochintegrierte Halbleiterschaltungen, basierend auf dem Master-Slice-Prinzip mit in einem Halbleiterchip integrierten, gegeneinander isolierten und in einer Matrix mit O bis m Spalten angeordneten Zellen unterschiedlichen Typs, die über mehrere Verdrahtungsebenen entsprechend einer vorgegebenen Funktion verbunden sind sowie ein Verfahren zur Herstellung einer derartigen Halbleiterschaltung.

Eine Halbleiterschaltung der eingangs genannten Art sowie ein Verfahren zu ihrer Herstellung sind aus der FR—A—2 365 883 bekannt.

Eine integrierte Halbleiterschaltung besteht aus Funktionsschaltungen, die integriert auf einem Halbleitersubstrat ausgebildet werden, so daß integrierte Schaltungen verwendende Schaltkreise gekennzeichnet sind durch ihre kleinen Abmessungen und eine bemerkenswert hohe Zuverlässigkeit im Betrieb. Die integrierten Halbleiterschaltungen sind daher auf zahlreichen Gebieten und Anwendungen, wie beispielsweise in Datenverarbeitungssystemen, wo Information oder Daten mit großen Genauigkeit und Geschwindigkeit verarbeitet werden sollen, von großem Wert. Daher werden die meisten Schaltungen und insbesondere logische Schaltungen oder dergleichen in Form von integrierten Schaltungen ausgeführt. Auf dem Gebiet der Halbleitertechnik wurden und werden große Anstrengungen unternommen, um die Integrationsdichte der Schaltungskomponenten auf einem Halbleitersubstrat oder Chip zu erhöhen. Mit dem Fortschritt der Fertigungstechniken integrierter Schaltungen führten diese Bemühungen dazu, daß eine wesentlich ausgeweitete Funktion auf einem einzelnen integrierten Halbleiterchip ausgeführt werden kann.

Der Ausdruck Zelle wird hier zur Bezeichnung einer Grundfunktionsschaltung (Halbleiterstruktur) benutzt, mit der eine komplexere Schaltung, ein Untersystem oder ein System aufgebaut wird. Die Einheitszelle oder Zelle kann z. B. ein UND-Glied, ein NAND-Glied, ein ODER-Glied, eine Flip-Flop-Schaltung oder dergleichen sein. Der Ausdruck "LSI-Schaltung" dient zur Bezeichnung einer Schaltung, die mehrere untereinander verbundene Zellen auf einem Halbleiterchip enthält. Der Ausdruck "LSI-Schaltung" dient auch zur Bezeichnung einer wesentlich höheren Anzahl integrierter Schaltungskomponenten im Vergleich zu einer Einheitszelle.

Im Konzept kann die LSI-Schaltung als Weiterentwicklung oder Erweiterung der konventionellen integrierten Schaltung betrachtet werden. Da in der LSI-Schaltung jedoch eine beachtliche Anzahl von Schaltungskomponenten auf einem Chip enthalten sein muß in der Praxis auch eine Anzahl von Komplikationen angesprochen werden, insbesondere die Zellengröße, der Zelleninhalt, die Zellenkonfiguration, die Verbindung der Zellen untereinander usw. Diese Komplikationen und Probleme, und insbesondere hier die Verdrahtung, sind nicht annähernd so komplex und lassen sich wesentlich leichter bei der Herstellung konventioneller integrierter Schaltungen lösen. Bei der Herstellung integrierter Schaltungen auf herkömmliche Art waren die üblichen Konstruktionstechniken sehr wirkungsvoll. (Die übliche Konstruktionstechnik, wie sie in Fachkreisen bekannt ist, läßt sich definieren als die größte Ausnutzung der Fläche des Halbleiterchips für die Implementierung nur eines Teiles der Schaltungen auf einem bestimmten Chip durch einzelne Festlegung der Lage der Komponenten und der Verdrahtung für jede erforderliche Schaltung). Die herkömmliche Konstruktionstechnik war und ist sehr effektiv bei der Fertigung konventioneller integrierter Schaltungen und führt im allgemeinen zu einem insgesamt weniger dicht gepackten Chip aufgrund der weniger dichten Verdrahtung zwischen dicht gepackten Schaltungsgruppen. Die herkömmliche Konstruktion verlangt auch eine beachtliche Menge an Zeit und Konstruktionsaufwand für ein bestimmtes System oder Untersystem und ist nicht praktisch bei der Fertigung vieler hochgradig integrierter Halbleiterschaltungen, wo die Schaltungsdichte sehr hoch, die Schaltung kompliziert ist und ausgedehnte, dichte und komplizierte Verdrahtungen erforderlich sind. Einer der stärksten Gründe, aus denen die herkömmliche Konstruktionstechnik für LSI-Halbleiterschaltungen nicht geeignet oder wirksam ist, liegt darin, daß sie für jede einzelne LSI-Schaltung die Entwicklung von Masken sowohl für die Dotierung zur Ausbildung der Schaltungselemente als auch für die Verdrahtung der Schaltungselemente erfordert.

Um die Nachteile der üblichen Konstruktionstechnik zu überwinden, wurde schon eine Anzahl anderer Lösungen vorgeschlagen, von denen eine auf dem sogenannten Master-Slice-Prinzip basiert. Bei diesem Prinzip wird zunächst eine große Anzahl von Schaltungselementen oder Zellen auf einem Halbleiterchip ausgebildet, um dann durch Veränderung des Musters der metallischen Verdrahtung eine Anzahl verschiedener LSI-Schaltungen herstellen zu können. Jede Schaltung aus einer Anzahl von LSI-Schaltungen kann bekanntlich durch entsprechende Verbindung bereits ausgebildeter Schaltungselemente oder Zellen hergestellt werden. Die Lösung nach dem Master-Slice-Prinzip hat den Vorteil, daß dieselbe(n) Diffusionsmaske(n) verwendet werden kann, um mehrere verschiedene LSI-Schaltungen einfach dadurch herzustellen, daß man geeignete Masken für die Verdrahtung für jede LSI-Schaltung entwickelt. Die Herstellung der Verdrahtung ist der letzte Fabrikationsschritt im Prozeß bei der Herstellung von LSI-Halbleiterschaltungen. Wie bereits gesagt, sind die herkömmliche Konstruktionslösung und auch die Lösung nach dem Master-Slice-Prinzip zur Herstellung von LSI-Halbleitern in Fachkreisen allgemein bekannt.

Der Stand der Technik ist des weiteren genauer beschrieben in den nachfolgend aufgeführten US-Patentschriften. US-Patenschrift No. 3 312 871 mit dem Titel "Interconnection Arrangement for Integrated Circuits"; US-Patentschrift No. 3 377 513 mit dem Titel "Integrated Circuit Diode Matrix"; US-Patentschrift No. 3 423 822 mit dem Titel "Method of making Large Scale Integrated Circuit"; US-Patentschrift No. 3 475 621 mit dem Titel "Standarized High Density Integrated Circuit Arrangement and Method"; US Patentschrift No. 3 484 932 mit dem Titel "Method of Making Integrated Circuits"; US-Patentschrift No. 3 553 830 mit dem Titel "Method for Making Integrated Circuit Apparatus"; US-Patentschrift No. 3 558 992 mit dem Titel "Integrated Circuit Having Bonding Pads Over Unused Active Area Components"; US Patentschrift No. 3 581 385 mit dem Titel "Method for Fabricating Large Scale Integrated Circuits with Discretionary Wiring"; US-Patentschrift No. 3 598 604 mit dem Titel "Process of Producing An Array of Integrate Circuits on Semiconductor Substrate"; US-Patentschrift No. 3 615 463 mit dem Titel "Process of Producing An Array of Integrated Circuits on Semiconductors Substrate"; US-Patentschrift No. 3 618 201 mit dem Titel "Method of Fabricating LSI Circuits"; US-Patenschrift No. 3 689 803 mit dem Titel "Integrated Circuit Structure Having A Unique Surface Matallization Layout"; US-Patentschrift No. 3 702 025 mit dem Titel "Discretionary Interconnection Process"; US-Patentschrift No. 3 707 306 mit dem Titel "Method for Fabricating Semiconductor LSI Circuit Devices"; US-Patentschrift No. 3 762 037 mit dem Titel "Method of Testing for the Operability of Integrated Semiconductor Circuits Having A Plurality of Separable Circuits"; US-Patentschrift No. 3 771 217 mit dem Titel "Integrated Circuit Arrays Utilizing Discretionary Wiring and Method of Fabricating Same"; US-Patentschrift No. 3 795 972 mit dem Titel "Integrated Circuit Interconnections by Pad Relocation"; US-Patentschrift No. 3 795 973 mit dem Titel "Multi-Level Large Scale Integrated Circuit Array Having Standard Test Points"; US-Patentschrift No. 3 795 974 mit dem Titel "Repairable Multi-Level Large Scale Integrated Circuit"; US-Patentschrift No. 3 795 975 mit dem Titel "Multi-Level Large Scale Complex Integrated Circuit Having Functional Interconnected Circuit Route to Master Patterns"; US-Patentschrift No. 3 981 079 mit dem Titel "LSI Chip Construction and Method"; US-Patentschrift No. 3 983 619 mit dem Titel "Large Scale Integrated Circuit Array of Unit Cells and Method of Manufacturing Same"; US-Patentschrift No. 3 984 860 mit dem Titel "Multi-Function LSI Wafers"; US-Patentschrift No. 3 993 934 mit dem Titel "Integrated Circuit Structure Having a Plurality of Separable Circuits"; US-Patentschrift No. 3 999 214 mit dem Titel "Wireable Planar Integrated Circuit Chip Structure"; US-Patentschrift No. 4 006 492 mit dem Titel "High Density Semiconductor Chip Organization"; US-Patentschrift No. 3 783 254; US-Patentschrift No. 4 032 962 mit dem Titel "High Density Semiconductor Integrated Circuit Layout"; US-Patentschrift No. 3 539 876 mit dem Titel "Monolithic Integrated Structure Including Fabrication Thereof" und US-Patentschrift No. 3 633 268 mit dem Titel "Method of Producing One or More Large Integrated Semiconductor Circuits".

Wie aus dem in oben angeführten Patentschriften beschriebenen Stand der Technik bekannt ist, gibt es zahlreiche Verfahren zur Herstellung von Halbleiterschaltungen, und wenigstens einige der Techniken werden auch angewandt. Bekannte Verfahren können der Einfachheit halber allgemein unterteilt werden in herkömmliche Verfahren und Verfahren nach dem Master-Slice-Prinzip. Die bekannten Techniken der metallischen Verdrahtung lassen sich allgemein unterteilen in die Techniken der fixen Verbindung, der beliebigen Verbindung und der Hybridverbindung, wobei unter Hybridverbindung eine Verdrahtungstechnik verstanden wird, die wenigstens teilweise die Merkmale der fixen und der beliebigen Verbindungstechniken kombiniert. Bisher wurden in der Technik zahlreiche Verdrahtungsverfahren nach der obigen allgemeinen Einteilung verwendet.

Die Erfindung, wie sie in den Ansprüchen gekennzeichnet ist, löst die Aufgabe, bei nach dem Master-Slice-Prinzip hergestellten LSI-Schaltungen die Dichte der Schaltungen bzw. der zum Aufbau dieser Schaltungen verwendeten Zellen und der Verdrahtung beträchtlich zu erhöhen.

Zum Stand der Technik gemäß Art. 54.3 gehört eine in der EU—A—0 001 209 beschriebene Halbleiterschaltung gemäß dem ersten Teil des Anspruchs 1, bei der ferner die Spalten 1 bis m-1 nur Zellen eines ersten und zweiten Typs enthalten, und bei der die Oberfläche des Halbleiterchips im wesentlichen vollständig für die Bildung der Zellen des ersten und zweiten Typs ausgenutzt wird. Ferner gehören zu diesem Stand der Technik die Merkmale der kennzeichnenden Teile der Ansprüche 2, 3, 4 und 8.

Aus der Zeitschrift IBM-Technical Disclosure Bulletin, Vol. 20, No. 8, Januar 1978 ist ein Verfahren zur Herstellung einer hochintegrierten Halbleiterschaltung bekannt, bei dem vier Metallisierungsebenen verwendet werden.

Bei der erfindungsgemäßen Halbleiterschaltung wird im wesentlichen die gesamte Halbleiteroberfläche mit Ausnahme von Isolationsbereichen zwischen den Zellen und einem Grenzbereich von eingeschränkter Breite am Umfang des Chips für Schaltungszellen verwendet. Die Schaltungs- oder Einheitszellen liegen dicht nebeneinander. Der Abstand zwischen den Zellen wird für die elektrische Isolation benutzt. Ein schmaler Bereich am Umfang des Chips wird ebenfals nicht benutzt. (Das ist der Randbereich des Chips vor dem Schneiden, der mehrere Physikalische Unregelmäßigkeiten aufweisen kann.) Die Einheitszellen auf dem Chip können unterschiedliche Größe, Konfiguration, Komponenteninhalt und Funktion haben.

Im gezeigten Ausführungsbeispiel der Erfindung haben jedoch bis auf eine begrenzte Anzahl von Zellen alle Zellen die gleiche Konfiguration, den gleichen Komponenteninhalt und sie belegen die gleiche Chipfläche. Wie aus der genaueren Beschreibung noch hervorgehen wird, sind alle Zellen in einer Matrix in Spalten und Zeilen angeordnet, und zwar ist die Mehrzahl der Zellen in Bündeln von vier Zellen so angeordnet, daß jede Zelle eine eindeutige geometrische Orientierung zu den übrigen drei Zellen ihres Bündels hat. Jede Zelle ist so ausgelegt, daß sie ein Minimum an Halbleiterfläche entsprechend den folgenden Faktoren belegt: (1) eine Konfiguration der Zellenfläche, die die Verdrahtung dadurch erleichtert, daß die aktiven Bereiche der Zelle so angeordnet werden, daß die Verdrahtungsdichte verbessert wird; (2) eine Konfiguration der Zellenfläche, die die wirksame Ausnutzung besagter Zelle in einer aus Spalten und Zeilen bestehenden Matrix einschließlich der Zellen erleichtert, die einen anderen Flächenbedarf haben; (3) eine Konfiguration der Zellenfläche und -größe einer jeden Zelle in Übereinstimmung mit der Konfiguration der Zellenfläche und Größe eines jeden anderen Zellentyps auf dem Halbleiterchip, um dadurch die Verdrahtungsdichte auf dem Chip zu verbessern, und (4) Zellenfläche und Konfiguration in Verbindung mit in jeweils dichtem Abstand angeordneten ersten und zweiten Verdrahtungsebenen, um ein Maximum besagter Zellen oder auch aller Zellen in einer integrierten Schaltung nutzen und dadurch die Funktionen (System, Logik usw.) ausweiten zu können, die von der auf einem einzigen Halbleiterchip angeordneten integrierten Schaltung wahrgenommen werden können.

Wenigstens eine erste und eine zweite dichte Verdrahtungsebene weisen die Form einer hochgradig integrierten Schaltung auf, die folgende Vorteile und Merkmale aufweist: (1) erhöhte Schaltungsdichte mit entsprechender Ausweitung der System-, der Logik- oder der Speicherfunktion, die durch ein integriertes Halbleiterchip ausgeführt werden kann, und (2) ein integriertes Halbleiterchip mit einer sehr großen Anzahl verdrahtbarer Zellen unter Ausnutzung der Master-Slice-Technik, durch die eine beträchtliche Anzahl verschiedener "Teile-Nummern" leicht herzustellen ist.

Ausführungsbeispiele der Erfindung sind in den beigefügten Zeichnungen dargestellt und werden anschließend näher beschrieben.

Es zeigen:

Fig. 1 eine vergrößerte Draufsicht eines Halbleiterchips mit einer Zellenkonfiguration, Struktur und Anordnung nach der Erfindung.

Fig. 2 eine vergrößerte Draufsicht eines Bündels von vier gleichen Zellen in der Struktur gemäß Fig. 1. Diese Zellen werden nachfolgend Zellen des ersten Typs genannt.

Fig. 2A bei Betrachtung in Verbindung mit Fig. 2 die geometrische Anordnung einer jeden Zelle in jedem Bündel aus vier gleichen Zellen.

Fig. 2B eine Schottky-Transistorlogikschaltung. Das schematische Schaltbild entspricht der integrierten Schaltung einer der vier Zellen der Fig. 2 nach der Personalisierung (Verdrahtung innerhalb der Zelle)

Fig. 2C ähnlich Fig. 2 im einzelnen eine vergrößerte Draufsicht eines Bündels aus vier gleichen Zellen.

Fig. 2D eine Schnittansicht entlang der Linie 2D—2D einer repräsentativen Zelle des in Fig. 2C gezeigten Bündels aus vier gleichen Zellen.

Fig. 2E eine vergrößerte detailierte Draufsicht eines Teiles der Fig. 1 mit einer beträchtlichen Anzahl von Zellen des ersten Typs.

Fig. 2F eine vergrößerte detailierte Ansicht eines Teiles der Zellenstruktur eines verdrahteten Halbleiterchips.

Fig. 3 eine vergrößerte Draufsicht eines Bündels aus zwei gleichen Zellen des zweiten in Fig. 1 gezeigten Typs sowie die geometrische Anordnung einer jeden Zelle in jedem Bündel.

Fig. 3A ein Schaltbild der beiden Zellen der Fig. 3.

Fig. 4 eine vergrößerte Draufsicht einer wenigstens teilweise personalisierten Schottky-Dioden-Transistorlogik (STL) als Spannungsreglerzelle (Zellentyp Nr. 3) auf dem Chip, in Fig. 1 dargestellt als Zelle VR.

Fig. 4A das Schaltschema der Schaltung, die durch die in Fig. 4 gezeigte Zelle nach der vollen Personalisierung gebildet wird.

Fig. 5 eine vergrößte Draufsicht eines wenigstens teilweise personalisierten STL-Gegentakt-Treibers aus dem Zellentyp Nr. 4 des in Fig. 1 gezeigten Chips.

Fig. 5A das Schaltbild der in Fig. 5 dargestellten Zelle bei voller Personalisierung.

Fig. 6 eine vergrößerte Draufsicht einer wenigstens teilweise personalisierten STL-Treibers aus dem Zollentype Nr. 4.

Fig. 6A das Schaltschema der in Fig. 6 gezeigten Zelle bei voller Personalisierung.

Fig. 7 eine vergrößerte Draufsicht einer wenigstens teil-weise personalisierten STL-Gleichtakt-Empfängers aus 2 Zellen vom Typ Nr. 1 des Chips in Fig. 1.

Fig. 7A das Schaltbild der in Fig. 7 dargestellten Zelle bei voller Personalisierung.

Fig. 8 eine vergrößerte Draufsicht einer wenigstens teilweise personalisierten UND-Inverterschaltung aus einer Zelle vom Typ Nr. 1 des in Fig. 1 gezeigten Chips.

Fig. 8A das Schaltbild der in Fig. 8 dargestellten Zelle (ohne Benutzung des Widerstandes RC).

Fig. 8B eine vergrößerte Draufsicht einer wenigstens teilweise personalisierten UND-Inverterschaltung des in Fig. 1 dargestellten Chips.

Fig. 8C das Schaltbild der in Fig. 8B gezeigten Zelle bei voller Personalisierung (unter Verwendung des Widerstandes RC).

Fig. 9 eine vergrößerte Schnittansicht eines kleinen Teiles einer erfindungsgemäßen Struktur unter besonderer Darstellung der vier Verdrahtungsebenen.

Fig. 10 eine vergrößerte Draufsicht der äußersten freiliegenden Verdrahtungsebene des vollständig hergestellten Halbleiterchips. Es handelt sich um eine Gruppe von Lötkontakten vorzugsweise aus Blei/Zinn oder gleichwertigem Material, die über dazwischen liegende Verdrahtungsebenen auf dem Chip eine elektrische Verbindung zwischen der auf der Oberfläche des Chips befindlichen integrierten Schaltung und außerhalb des Chips liegenden elektrischen Schaltungen herstellen.

Fig. 11A eine Draufsicht einer Maske für die Durchgangslöcher in der vierten Isolierschicht zur Verbindung der dritten Verdrahtungsebene mit der vierten Verdrahtungsebene, die in Fig. 10 gezeigt ist.

Fig. 11B eine Draufsicht einer Maske für die dritte Verdrahtungsebene.

Fig. 11C eine Draufsicht einer Maske für die Durchgangslöcher in der dritten Isolierschicht zur Verbindung der zweiten mit der dritten Verdrahtungsebene.

Fig. 11D eine Draufsicht einer Maske für die zweite Verdrahtungsebene.

Fig. 11E eine Draufsicht einer Maske für die Durchgangslöcher in der zweiten Isolierschicht zur Verbindung der ersten mit der zweiten Verdrahtungsebene.

Fig. 11F eine Draufsicht einer Maske für die erste Verdrahtungsebene.

Fig. 11G eine Draufsicht einer Maske für die Kontaktöffnungen in der ersten Isolierschicht zur Verbindung der ersten Verdrahtungsebene mit den aktiven Bereichen des Halbleiterchips.

Fig. 12A bis 12D Schnittansichten eines Teiles einer erfindungsgemäßen integrierten Schaltung in aufeinanderfolgenden Herstellungsstufen.

Fig. 12E eine Draufsicht auf den fertigen Teil einer hochgradig integrierten Schaltung, wie sie in den Fign. 12A bis 12D in aufeinanderfolgenden Herstellungsstufen dargestellt ist und

Fig. 12F eine Schnittansicht der in Fig. 12E gezeigten Struktur entlang der Linie 12F——12F in Fig. 12E.

Da sich die Erfindung hauptsächlich auf der Struktur von hochgradig integrierten Schaltungen (LSI-Schaltungen) in Verbindung mit ihrer Verdrahtung (personalisiertes Metallmuster) und nicht in einem spezifischen Halbleiterprozeß zur Bildung integrierter Schaltungen oder isolierter Metallmuster bezieht, werden anschließend die Prozesse zur Herstellung integrierter Schaltungen und der verschiedenen Verdrahtungsebenen nicht so ausführlich beschrieben. Die Herstellung personalisierter Kontakte zur Chipfläche ist jedoch Teil des Halbleiterprozesses und wichtig für die Erzielung einer hohen Packungsdichte gemäß der Erfindung. Die Grundschritte des Halbleiterprozesses werden daher beschrieben. Soweit nichts anderes angegeben ist, kann angenommen werden, daß die Halbleiterelemente in der integrierten Schaltung sowie die isolierten Verdrahtungsebenen (Metallisierung) in herkömmlichen photolithographischen Prozessen durch Diffusion oder Ionenimplantation bzw. mehrschichtige Verdrahtung hergestellt werden können. Erfindungsgemäß verbesserte, hochgradig integrierte Schaltungen können beispielsweise in Prozessen hergestellt werden, wie sie unter anderem beschrieben sind in den US-Patentschriften No. 3 539 876 oder 3 656 028. Für die Herstellung der verschiedenen Verdrahtungsebenen sowie der diese trennenden Isolierschichten und der Durchgangslöcher oder Bohrungen in den Isolierschichten zur Verbindung der verschiedenen Verdrahtungsebenen wird verwiesen auf die US-Patentschriften No. 3 558 992, 3 725 743 und 3 539 876.

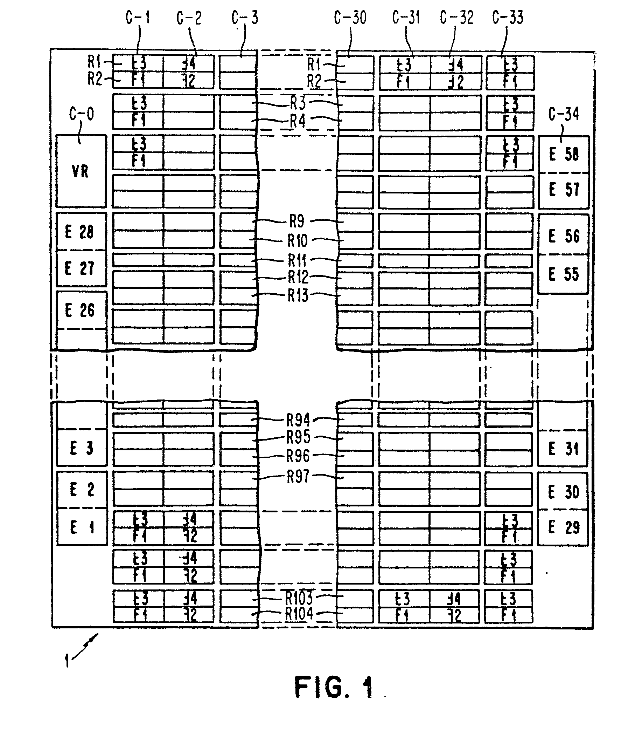

In Fig. 1 ist die Struktur der Zellen (Einheitszellen) in der Oberfläche eines Chips 1 (LSI-Chip) dargestellt. Die Zellen sind in einem bestimmten Abstand voneinander in 35 Spalten nebeneinander angeordnet, die mity C-0 bis C-34 in X-Richtung bezeichnet sind. Die Spalte C-0 enthält 29 Zellen mit den Bezeichnungen E1 bis E28 und VR. Die Spalte C-34 enthält 34 Zellen mit der Bezeichnung E29 bis E58. Die Zellen E1 bis E58 der Spalten C-0 bis C-34 sind richtiger als 29 Zellenpaare zu betrachten, die im nutzbaren möglichen Komponenteninhalt (Widerstände, Transistoren, usw.) miteinander identisch sind. Nebeneinanderliegende Zellen E1 und E2 bilden ein Paar wie z.B. auch die Zellen E3, E4, usw. bis E57 und E58. Die Spalten C-1 bis C-33 enthalten jeweils 104 Zeilen, die zeilenweise streng auf die 104 Zeilen der übrigen Spalten ausgerichtet sind. Mit Ausnahme der geometrischen Anordnung und der Zeilen R11, R24, R43, R62, R81 und R94 ist jede der Zellen in den Spalten C-1 bis C-33 inihrer Halbleiterstruktur identisch (d.h. in den aktiven Bereichen, den nutzbaren Transistoren, Widerständen und Schottky-Dioden). Anders ausgedrückt heißt das, die Zellen der Spalten C-1 bis C-33 enthalten Zellen eines ersten und eines zweiten Typs. Wie später noch genauer erklärt wird, ist jede der Zellen des ersten Typs in den Zeilen R1 bis R10, R12 bis R23, R25 bis R42, R44 bis R61, R63 bis R80, R82 bis R93 und R95 bis R104 in jeder der Spalten C-1 bis C-33 insofern identisch, als die Zellen dieses ersten Typs mit Ausnahme der Spalte C-33 in Bündeln von vier unabhängigen Zellen F1, F2, F3, F4 so angeordnet sind, daß jede Zelle eines jeden Bündels geometrisch eindeutig in Bezug auf die übrigen drei Zellen ihres Bündels ausgerichtet ist. Die Zeilen R12, R24, R43, R62, R81 und R94 einer jeden Spalte C-1 bis C-33 enthalten Zellen des zweiten Typs, die miteinander in Halbleiterstruktur, Fläche, Konfiguration und möglicherweise nutzbaren Komponenten insofern identisch sind, als die Zellen des zweiten Typs in den Spalten C-1, C-3, C-5 bis C-33 eine andere geometrische Orientierung zu den Zellen des zweiten Typs der Spalten C-2, C-4, C-6 bis C-32 haben.

Das in Fig. 1 gezeigte Halbleiterchip 1 aus Silicium hat eine Größe von 4,669 × 4,669 mm² und enthält insgesamt 3491 Einheitszellen, nämlich 58 Zellen E1 bis E58, eine Zelle VR, 3234 besagten ersten Typs und 198 besagten zweiten Typs. Die in dieser Beschreibung gemachten Angaben über Anzahl der Zellen, Zellentyp, Zelleninhalt, Zellenkonfiguration, Chipgröße, usw. dienen lediglich zur Erklärung Zahlreiche Modifikationen der beschriebenen Ausführungsbeispiele sind möglich.

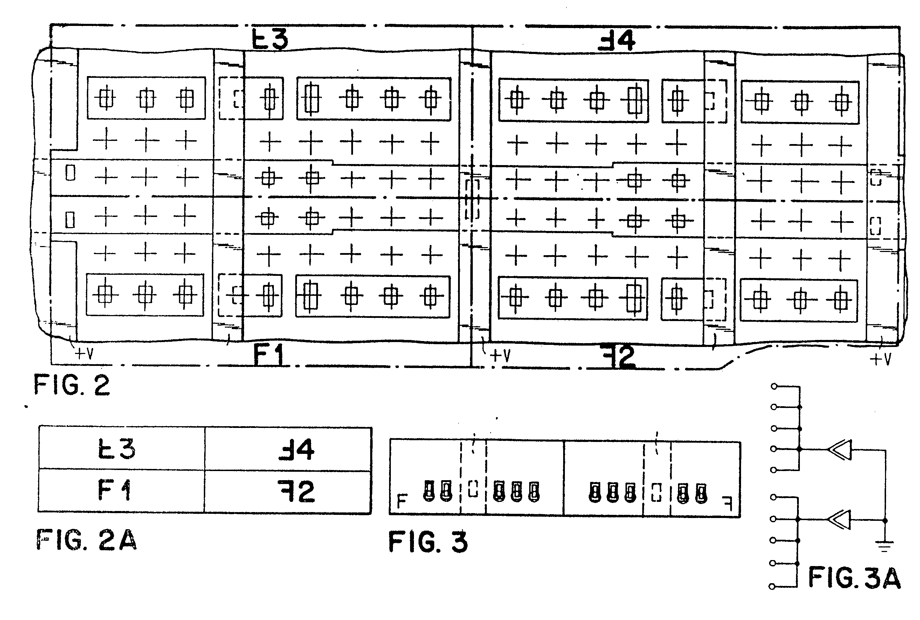

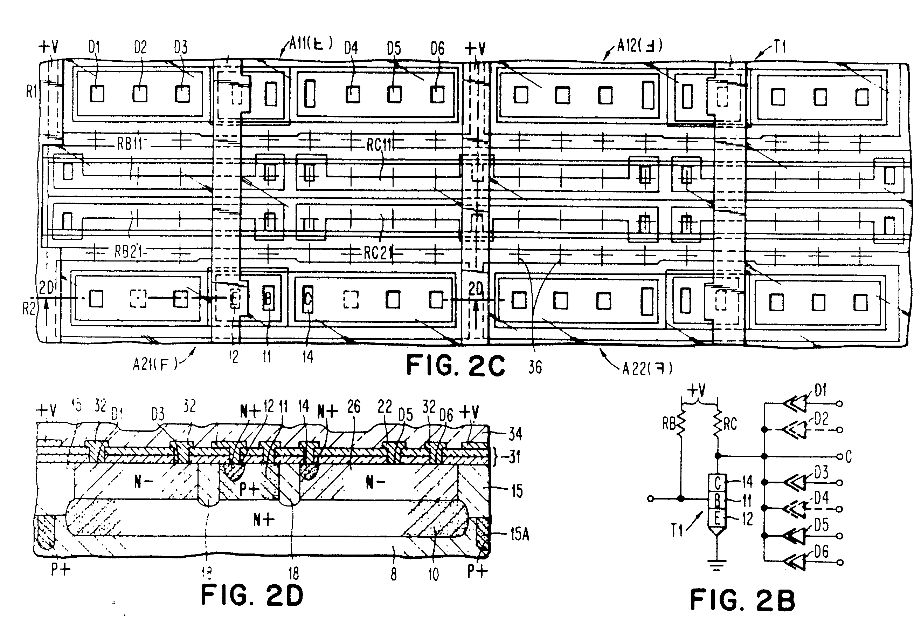

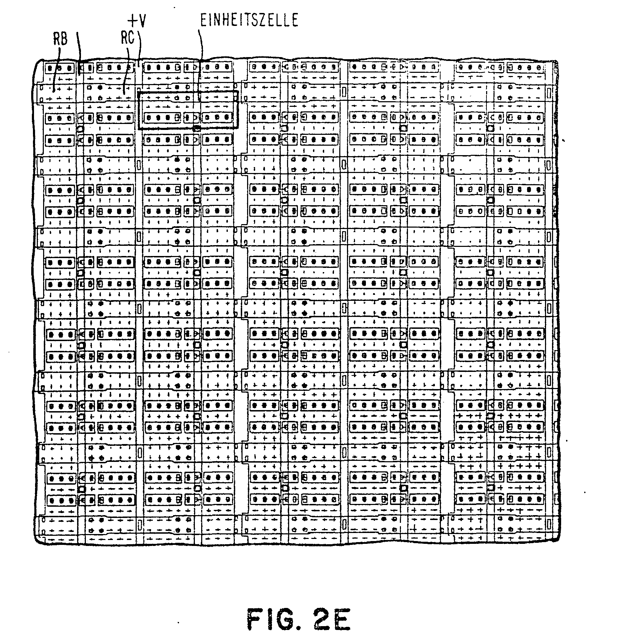

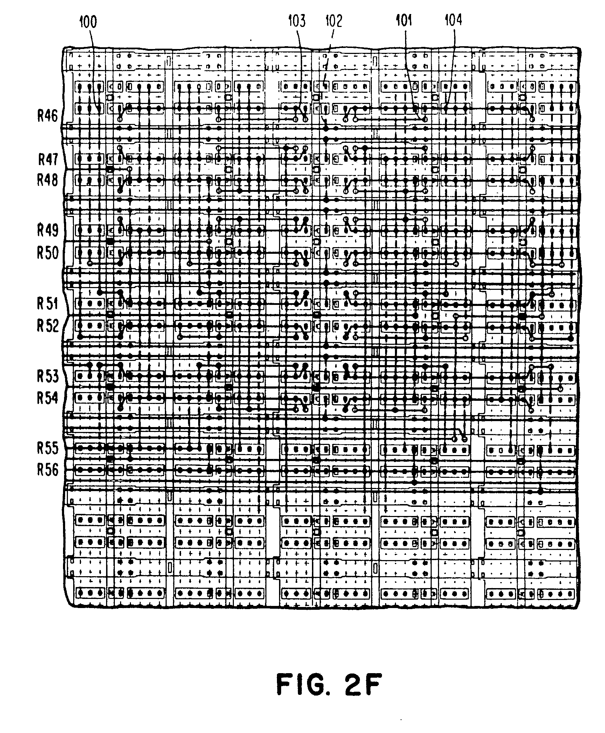

Fig. 2 zeigt eine vergrößerte Draufsicht auf ein Bündel von vier Zellen des genannten ersten Typs. Fig. 2A zeigt ein Rechteck, das in vier gleichgroße Rechtecke unterteilt ist, von denen jedes eine Einheitszelle des ersten Typs darstellt und den Buchstaben F in unterschiedlicher Orientierung enthält. Die Orientierung des Buchstabens F in den vier Rechtecken der Fig. 2A und Fig. 2 zeigt die Orientierung zueinander der Zellen des ersten Typs in dem Viererbündel. Wie aus Fig. 1 zu ersehen ist, wird diese Orientierung der Zellen des ersten Typs beibehalten in den Zellenspalten C-1 bis -32. Die Draufsicht des Bündels aus vier Zellen des ersten Typs in den Fig. 2 und 2A entspricht beispielsweise in der Orientierung den Zellen des ersten Typs in den Spalten C-1 und C-2, Zeile R1 und R2 der Spalten C-31 und C-32, Zeilen R103 und R104, wobei zu berücksichtigen ist, daß die Zeilen R11, R24, R43, usw. der Spalten C-1 und C-32 Zellen des genannten zweiten Typs enthalten. Die Spalte C-33 ist in Zelleninhalt und Zellenorientierung jeder ungeraden Spalte C-1, C-3, usw. C-31 identisch.

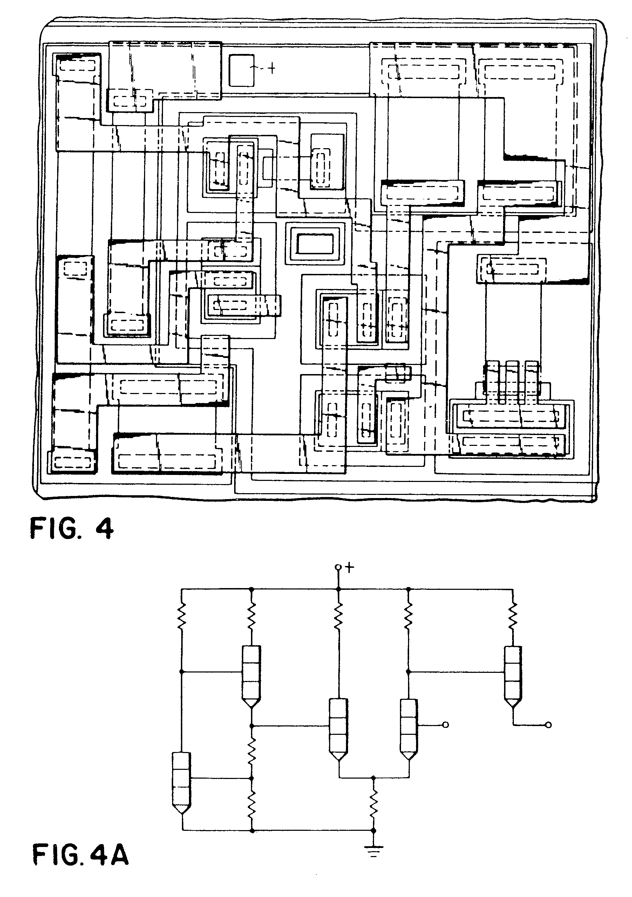

Fig. 3 zeigt eine Draufsicht erster und zweiter Zellen des zweiten Typs. Ein Rechteck ist in zwei gleiche Rechtecke unterteilt, von denen jedes eine Zelle des zweiten Typs umfaßt und den Buchstaben F in unterschiedlicher Orientierung enthält. Die Orientierung des Buchstabes F in den zwei Rechtecken der Fig. 3 zeigt die Orientierung des Zellen des zweiten Typs zueinander in Zweierbündeln. Die in einer gegebenen Zeile in den Spalten C-1, C-3 und C-4, C-5 und C-6 bis C-31 und C-32 enthaltenen Zellen des zweiten Typs sind in der in Fig. 3 gezeigten Weise orientiert. Die Spalte C-33 ist in Zelleninhalt und Orientierung jeder ungeraden Spalte C-1, C-3, . . . , C-31 identisch.

Aus Fig. 1 ist zu ersehen, daß die Spalten C-1, C-3, C-5, . . . , C33 abgesehen vom ihrem entsprechenden Abstand von den Zellenspalten C-0 und C-34 miteinander identisch sind. Ebenso sind die Zellenspalten C-2, C-4, C-6, . . . , C32 mit Ausnahme ihres Abstandes von den Zellenspalten C-0 und C-34 miteinander identisch. Jede gerade Zellenspalte C-2, C-4, C-6, . . . , C-32 stellt außerdem ein Spiegelbild der ungeraden Zellenspalten C-1, C-3, C-5, . . . , C-33 dar.

Bei der in Fig. 1 gezeigten Struktur der Zellen auf dem Halbleiterchip 1 wird im wesentlichen die ganze Fläche des Chips für Einheitszellen benutzt. Die einzigen Teile der Chipfläche, die keine Zellen enthalten, sind kleine Flächen in den Ecken des Chips. Diese werden bekanntlich üblicherweise für die Maskenausrichtung bei der Herstellung, für Prüfschaltungen und Muster und für die Chipidentifizierung benutzt. Weit wichtiger ist aber hier die Feststellung, daß keine Chipfläche für Verdrahtung oder Metallmuster verbraucht wird.

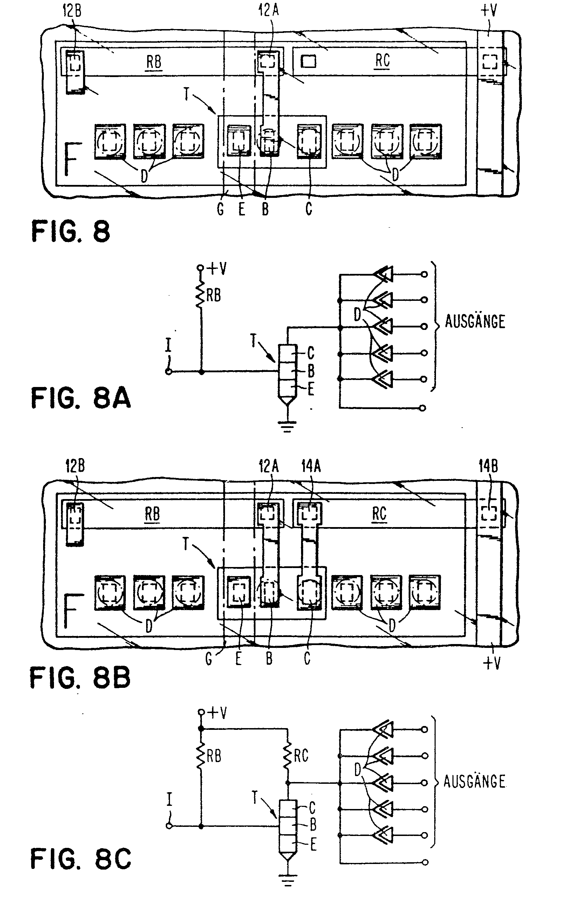

Nach Darstellung in den Fign. 1 und 2 kann jede Einheitszelle des ersten Typs so personalisiert werden, daß man eine integrierte STL-Schaltung (UND-Inverterschaltung) mit einem Schaltbild erhält, wie es entweder in Fig. 8A oder 8C gezeigt ist. Die Personalisierung der ersten Ebene (Verdrahtung) einer Zelle des ersten Typs, mit der man eine Schaltung wie in Fig. 8A gezeigt, erhält, ist in Fig. 8 dargestellt. Die Personalisierung der ersten Ebene einer Einheitszelle des ersten Typs, mit der man eine Schaltung gemäß Darstellung in Fig. 8C erhält, ist in Fig. 8B gezeigt. In der personalisierten Zelle der Fig. 8B ist der Widerstand RC mit dem Kollektor des Transistors T und der Potentialquelle V verbunden. Im Gegensatz dazu ist in der personalisierten Zelle der Fig. 8 der Widerstand RC nicht mit dem Kollektor des Transistors T und der Potentialquelle V verbunden.

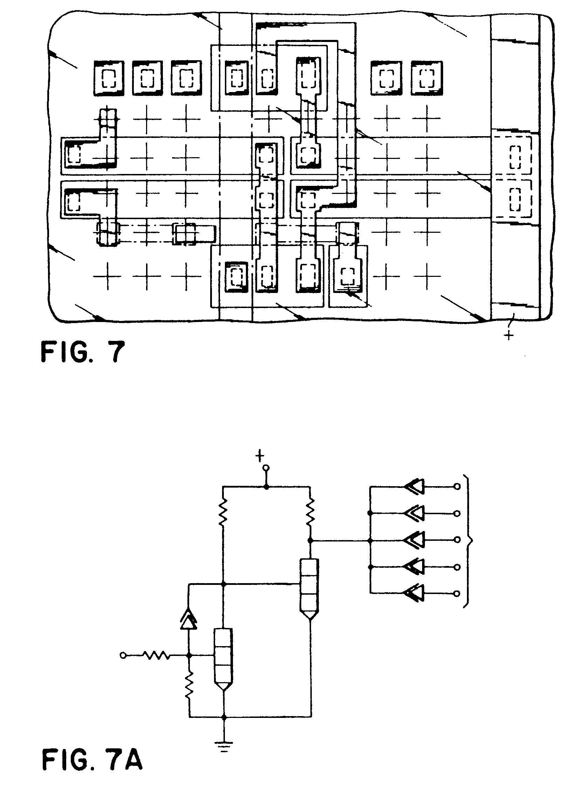

Zwei Zellen des ersten Typs können so personalisiert werden, wie es in Fig. 7 gezeigt ist, daß sie eine integrierte Schaltung ergeben, die das in Fig. 7A wiedergegebene Schaltbild hat. Hierbei handelt es sich um einen Gleichtakt-Empfänger in STL-Technik. Die einzige Einschränkung für die Wahl der beiden Zellen besteht darin, daß sie in derselben Spalte (C-1, C-3, C-5, . . . , C-33) nebeneinander liegen müssen, wobei eine Zelle in der Zeile mit einer ersten Nummer und die andere Zelle in der benachbarten höher numerierten Zeile so liegt, daß die Zellen zueinander die in Fig. 7 gezeigte Orientierung haben. In jeder ungeraden Spalte beispielsweise können zwei für die Personalisierung als Gleichtakt-Empfänger ausgewählte Zeilen aus einem oder mehreren der folgenden Zellenpaare bestehen: eine Zelle in Zeile eins und eine Zelle in Zeile zwei der gleichen ungeraden Spalte, eine Zelle in Zeile R25 und eine Zelle in Zeile R26 derselben ungeraden Spalte, eine Zelle in Zeile R44 und eine Zelle in Zeile R45 derselben ungeraden Spalte, eine Zelle in Zeile R92 und eine Zelle in Zeile R93 derselben ungeraden Spalte oder eine Zelle in Zeile R103 und eine Zelle in Zeile R104 derselben ungeraden Spalte. Man kann also auf dem Chip eine Anzahl Gleichtakt-Empfänger bei fast vollständig freier Wahl der Lage (Spalte und Zeile) eines jeden solchen Empfängers vorsehen. (Die obige Erwähnung der ungeraden Spalten ergibt sich lediglich aus der speziellen Konfiguration der im Ausführungsbeispiel verwendeten ersten Verdrahtungsstufe).

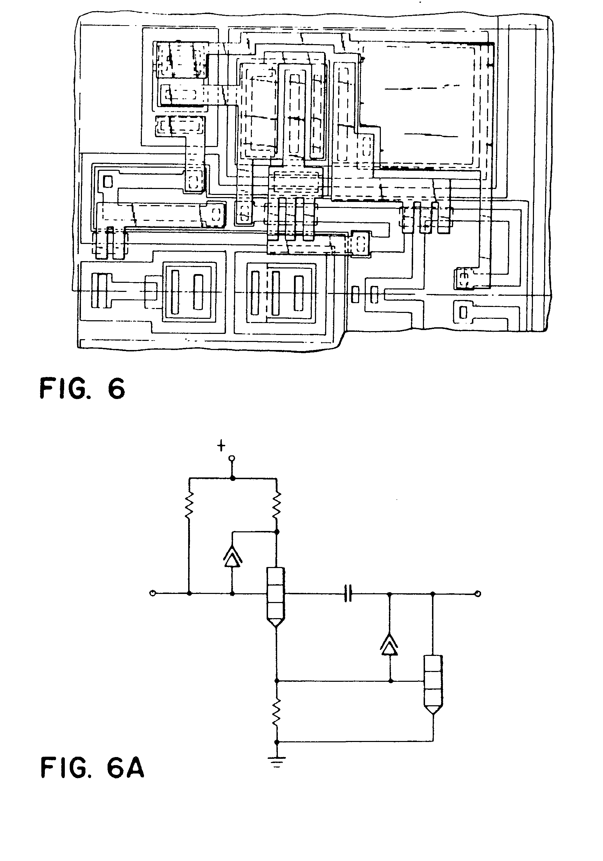

Von den in Fig. 1 gezeigten Zellen E1 bis E58 können eine oder mehrere Zellen so personalisiert werden, wie es in Fig. 6 gezeigt ist. Es ergibt sich ein integrierter STL-Treiber mit offenem Kollektor, dessen Schaltbild in Fig. 6A gezeigt ist. Unter Verwendung der Zellen E1 bis E58 kann man also 58 diskrete integrierte STL-Treiber mit offenem Kollektor vorsehen, wie er in den Schaltbildern der Fig. 6 und 6A gezeigt ist.

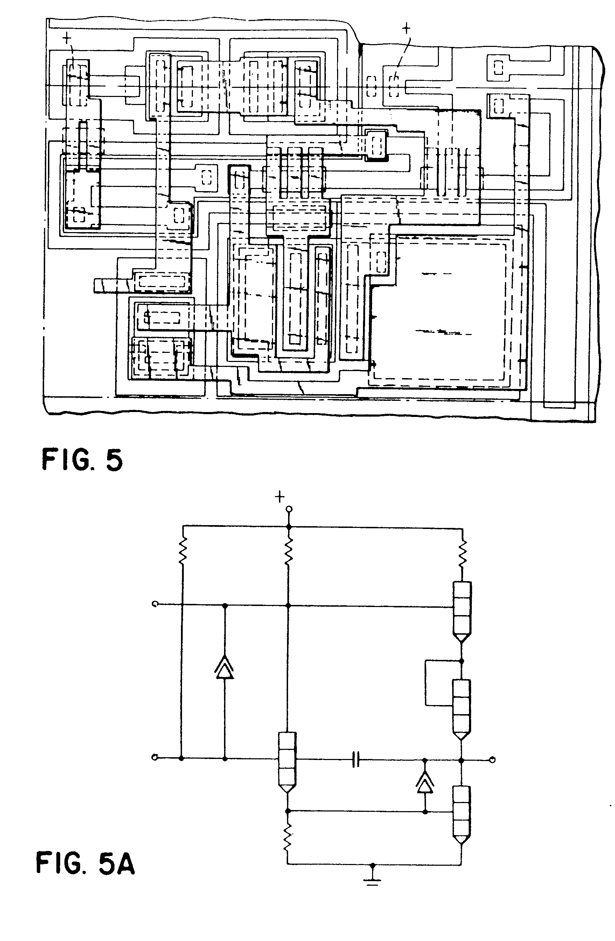

Von den in Fig. 1 gezeigten Zellen E1 bis E58 kann jede, höchstens jedoch 29, wie in Fig. 5 dargestellt zu einem integrierten Gegentakttreiber personalisiert werden. Das Schaltbild dieses Gegentakttreibers ist in Fig. 5A gezeigt. Zur Personalisierung als Gegentakttreiber kann aus den Zellen E1 bis E58 jede beliebige ausgewählt werden. Jedoch nicht beide Zellen der folgenden Paarungen: E1, E2; E3, E4; E5, E6 usw. sowie E57, E58. Wenn eine Zelle der erwähnten Paarungen zur Personalisierung als Gegentrakttreiber ausgewählt wird, kann die jeweils andere Zelle des Paares nur noch als Treiber mit offenem Kollektor personalisiert werden. Die oben getroffene Festlegung der Anzahl und der speziellen E-Zellentypen, die für die Personalisierung als Gegentakttreiber zur Verfügung stehen, ergibt sich aus der Tatsache, daß in diesem speziellen Ausführungsbeispiel jedes Zellenpaar vom Typ E nur so viele Bauteile enthält, daß ein Gegentakttreiber und ein Treiber mit offenem Kollektor vorgesehen werden kann.

Die in den Fig. 1 und 4 gezeigte Zelle VR kann als integrierter Spannungsregler personalisiert werden, dessen Schaltbild in Fig. 4A wiedergegeben ist. Obwohl in Fig. 1 nur eine solche VR-Zelle dargestellt ist, können auf dem Chip natürlich mehrere derartige Zellen vorgesehen werden.

Fig. 2C zeigt eine Draufsicht auf ein Bündel von vier Zellen besagten ersten Typs. Die Orientierung einer jeden Zelle in besagtem Bündel ist identisch mit der hier früher erklärten und in den Fign. 1, 2 und 2A gezeigten Orientierung. Fig. 2B zeigt das Schaltbild einer integrierten Schaltung, die durch jeweils vier Zellen der Fig. 2C gebildet werden kann, wenn geeignete Metallverbindungen hergestellt werden. Die Fig. 2D zeigt eine Schnittansicht der Struktur der Fig. 2C entlang der Linie 2D—2D.

In Fig. 2B ist eine Schottky-Transistorlogikschaltung zur Ausführung der NAND-Funktion gezeigt. Die logische Operation erfolgt bekanntlich durch Steuerung des Stromes von Widerstand RB. Wenn alle Eingangssignale an der Basis des Transistors T1 auf einem niedrigen Pegel liegen, leitet der Transistor T1 nicht und die Ausgangssignale an den Anoden der Schottky-Dioden D1, D2, D3, D4, D5 und D6 sind entsprechend auf dem oberen Pegel. Wenn eines oder mehrere Eingangssignale an der Basis des Transistors T1 auf dem oberen Pegel liegen, leitet der Transistor T1 und die Anoden der Schottky-Dioden sind entsprechend auf dem unteren Pegel. Wenn der Transistor T1 nämlich leitet, leitet auch jede Schottky-Diode. Durch logische Verbindung einer Anzahl von Schaltungen des in Fig. 2B gezeigten Typs auf vorgegebene Weise kann jeder aus einer Anzahl logischer Schaltkreise verwirklicht werden.

Fig. 2C zeigt eine Draufsicht auf die vier Zellen A11, A12, A21 und A22 des genannten ersten Typs. Die vier teilweise personalisierten Zellen sind entsprechend so ausgerichtet, wie es bereits in Zusammenhang mit den Fign. 1, 2 und 2A beschrieben wurde. Fig. 2D ist ein Querschnitt entlang der Linie 2D—2D. Mit Ausnahme der Orientierung ist jede Zelle des ersten Typs in Größe (Fläche), Konfiguration und verdrahtbarem Komponentengehalt identisch. Nachfolgend wird daher nur eine Zelle des ersten Typs im einzelnen beschrieben. Jede Zelle besteht aus mehreren Bereichen unterschiedlicher Leitfähigkeit (N order P), die in das Chip hineinverlaufen und so Transistoren, Dioden und Widerstände bilden. Diese Bereiche werden durch eine erste Metallisierungsebene (Verdrahtungsebene) untereinander verbunden, die einer ersten Isolierschicht 31 überlagert wird. Die Verbindung zwischen dem Widerstand RB und der Basis 11 des Transistors T1 ist beispielsweise mit dem Referenzzeichen 12A bezeichnet (Fig. 8). Die Verbindung zwischen dem Widerstand RC und dem Kollektor 14 des Transistors T1 ist bezeichnet mit 14A (Fig. 8A). Die Verbindung des Widerstandes RB mit einer +V Potentialsammelleitung ist bezeichnet mit 12B (Fig. 8). Die Verbindung des Widerstandes RC mit der +V Potentialsammelleitung ist bezeichnet mit dem Referenzzeichen 14B (Fig. 8B). Das Pluszeichen in Fig. 2C bezeichnet die Stelle, an der ein Teil der zweiten Verdrahtungsebene getragen von einer zweiten Isolierschicht 34 direkt über einem Teil der ersten Verdrahtungsebene überlagert wird. Die erste Verdrahtungsebene (Y-Richtung in den Fig. 2 und 2C) verläuft rechtwinklig zur zweiten Verdrahtungsebene (X-Richtung in Fig. 2 und 2C) und die Verdrahtungsebenen sind durch die Isolierschicht 34 voneinander getrennt.

Der in Fig. 2D gezeigte Transistor T1 enthält einen im Substrat 8 ausgebildeten länglichen Subkollektor 10 und ein Kollektorbereich 14, ein Basisbereich 11 und ein Emitterbereich 12 sind in der Epitaxialschicht 26 ausgebildet. Auf jeder Seite des Transistors T1 in der Epitaxialschicht 26 sind über dem Subkollektor 10 jeweils 3 der Schottky-Dioden D1, D2, D3, D4, D5 und D6 ausgebildet. Die Diodes D5 hat vom Kollektor einen relativ großen Abstand. Die Isolation zwischen den Schaltungen erfolgt durch einen P + Bereich 15A und einen vertieften Oxydbereich 15 auf bekannte Weise. Der Isolationsbereich 18 isoliert den Kollektorbereich 14 vom Basisbereich 11 und dem Emitterbereich 12. Die Dioden D2 und D4 sind in Fig. 2B nur angedeutet, da sie in Fig. 2D nicht personalisiert sind. Nach Darstellung in Fig. 2D wurde die notwendige Metallisierung nicht vorgesehen. Eine Schaltung des in Fig. 2B gezeigten Typs kann mit oder ohne Kollektorkontakt und 0 bis 6 Schottky-Dioden-Ausgängen hergestellt werden. Im bevorzugten Ausführungsbeispiel ist die Schaltung der Fig. 2B mit höchstens 4 der 6 Dioden ausgestattet. Längliche Zellenstrukturen mit einer beträchtlichen Anzahl von Eingängen sind veröffentlicht in der US-Patentschrift No. 4 032 962. Die relativ breiten Sammelleitungen, die einen Abstand von einander haben und mit +V bezeichnet sind, verlaufen in Y-Richtung oder Spaltenrichtung und liefern geeignete Potentiale an die Zellen der integrierten Schaltung. Die Sammelleitungen +V und GND sind laut Darstellung in Fig. 2D auf der Isolierschicht 31 angeordnet und bilden die erste Ver-drahtungs- oder Metallisierungsebene und ver-laufen rechtwinklig zur Längsrichtung der Zellen des ersten Typs A11 bis A22. Die Widerstände RB und RC der in Fig. 2B gezeigten Schaltung entsprechen den Widerständen RB21 und RC21 der Zelle A21, den Widerständen RB22 und RC22 der Zelle A22, usw. Die längliche Konfiguration der Zellen und die Art der Verdrahtung ermöglichen die Bildung der länglichen Widerstände RB und RC.

In einem bevorzugten Ausführungsbeispiel der Erfindung werden vier Verdrahtungsebenen benutzt. In den Fig. 2, C und 2D ist der Klarheit halber nur ein Teil der ersten Verdrahtungsebene dargestellt. Nur bestimmte Schottky-Dioden einer jeden zu verdrahtenden Zelle werden, wie schon gesagt, durch entsprechende Metallisierung und Verbindung über die erste Verdrahtungsebene 32 hergestellt. Zu verwendende oder zu Verdrahtende Zellen werden entsprechend personalisiert und zur Verbindung der erforderlichen Zellen zu einer integrierten Schaltung werden die erste und zweite Verdrah-tungsebene verwendet. Die möglichen Kreuzun-gen oder Schnittpunkte der ersten und zweiten Ebene, getrennt durch die Isolierschicht 34 (Fig. 2D), sind in Fig. 2C mit dem Bezugszeichen 36 bezeichnet. Die Verdrahtung der dritten Ebene, die nachfolgend beschrieben wird, ist vorzugsweise ein relativ festes Verdrahtungsmuster, das die zweite Ebene mit der vierten Ebene verbindet. Jede Zelle der in Fig. 1 gezeigten Schnittstruktur trägt somit vier Verdrahtungsebenen.

Fig. 2E zeigt im einzelnen einen Teil der Matrixanordnung von Zellen des ersten Typs, wie sie in Fig. 1 allgemeiner dargestellt ist. Bei Betrachtung der Fig. 2E in Verbindung mit Fig. 1 ist zu berücksichtigen, daß Zellen des zweiten Typs, wie sie in den Zeilen R11, R24, R43 usw. vorhanden sind, nicht dargestellt wurden. Die Zellen sind in einer Matrix aus Zeilen und Spalten angeordnet (siehe Spalten C-1 bis C-33, Zeilen R1 bis R104 in Fig. 1) und bedecken mit Ausnahme der Spalten C-O und C-34 die ganze Oberfläche des Chip. Die Spalten C-O und C-34 liefern die Treiberzellen E1 bis E58 und die Spannungsreglerzelle VR. Eine repräsentative Einheitzelle des ersten Typs ist in Fig. 2E entsprechend bezeichnet. Die Fig. 2E enthält außerdem die Bezeichnungen "RB", "RC" und "+V". Jede Einheitszelle des ersten Typs ist 120 $\mu$m lang und 42 $\mu$m breit. In Fig. 2E ist keine zelleninterne Verdrahtung oder eine Verdrahtung zwischen den Zellen gezeigt. Die Zellen können somit zu aktiven Schaltungen vorgegebener Funktion verdrahtet werden.

Wie bereits erwähnt, ist der Widerstand RB der verdrahteten Zellen ersten Typs zwischen der Basis des Transistors T1 und einem Sammelleiter +V der ersten Verdrahtungsebene angeordnet. Der Widerstand RC (falls erforderlich) liegt zwischen dem Kollektor des Transistors T1 und dem Sammelleiter +V. Der Emitter des Transistors ist an den Massesammelleiter GND der ersten Verdrahtungsebene geführt. Fig. 2F zeigt einen Teil der Anordnung von verdrahteten Zellen auf einem Halbleiterchip gemäß der Darstellung in Fig. 1. Der in Fig. 2F gezeigte verdrahtete Teil enthält fünf Spalten und elf Zeilen aus Zellen des ersten Typs, z.B. die Zellen der Spalten C-1 bis C-5 und die Zeilen R46 bis R56 der Zellenanordnung nach Fig. 1. Die in Fig. 2F gezeigten verdrahteten Zellen bilden eine integrierte Schaltung für die logische Makrofunktion eines Eingangsdecodieres. Im Betrieb empfängt der Decodierer Signale von Chipempfangsschaltungen, (verdrahtete Zellen des ersten Typs), decodiert diese Signale und überträgt Signale an ver-schiedene andere Funktionschaltungen (ver-drahtete Zellen des ersten Typs) auf dem Halbleiterchip. In Fig. 2F verlaufen gestrichelte Linien in Y-Richtung oder Spaltenrichtung und stellen eine erste Verdrahtungs- oder Metallisierungsebene dar. Die ausgezogenen Linien verlaufen in X-Richtung oder Zeilenrichtung und stellen eine zweite Verdrahtungs- oder Metal-lisierungsebene dar. Wie schon früher festgestellt, verläuft die erste Verdrahtungsebene orthogonal zur Längsrichtung einer jeden Zelle des ersten Typs und zur Verdrahtungsrichtung der zweiten Ebene. Die erste Verdrahtungsebene ist von der Oberfläche des Halbleiters durch die Isolierschicht 31 und von der zweiten Verdrahtungsebene durch die Isolierschicht 34 getrennt. Verbindungen von der ersten Ver-drahtungsebene zu den aktiven Halbleiterberei-chen innerhalb der Zelle erfolgen durch entsprechend plazierte mit Metall gefüllte Kontaktöffnungen in der Isolierschicht zwischen der ersten Verdrahtungsebene und der Oberfläche des Halbleiterchips. (Als repräsentatives Beispiel sind die personalisierten Kontakte in der Schnittansicht in Fig. 2D gezeigt). Die Verbindungen zwischen Leitern der ersten Ebene zu Leitern der zweiten Ebene erfolgen entsprechend ebenfalls über mit Metall gefüllte Öffnungen. Die Verwendung derartiger Offnungen zur Verbindung von Verdrahtungsebenen ist in Fachkreisen allgemein bekannt und wird daher nicht mehr beschrieben.

Die leitenden Kontakte, die in Fig. 2F die erste Verdrahtungsebene mit ausgewählten aktiven Halbleiterbereichen verbinden, werden auch personalisierte Zellenkontakte oder einfach personalisierte Kontakte genannt und sind durch ein ausgefülltes Rechteck dargestellt. Das ausgefüllte Rechteck mit dem Bezugszeichen 100 in Fig. 2F zeigt einen solchen personalisierten Kontakt. Unter aktiven Bereichen wird hier der die Emitter, die Basis und der Kollektor des Transistors sowie die Dioden in jeder Zelle verstanden. Bei der in Fig. 2B dargestellten Schaltung (Zelle des ersten Typs) sind die Emitter der Transistoren T1 und die beiden Widerstände RB und RC (falls RC zu verwenden ist) für jede zu verdrahtende Zelle angeschlossen. Der Klarheit halber sind diese Verbindungen in Fig. 2F nicht extra gezeigt. Obwohl sie in Fig. 2F nicht dargestellt sind, können auch Zellen des zweiten Typs, die Treiberzellen E1 bis E58 und die Zelle VR, in wesentlich derselben Weise verdrahtet werden.

Die Leitungsdurchführungen zwischen der ersten Verdrahtungsebene und der zweiten Verdrahtungsebene sind in Fig. 2F durch Kreise dargestellt, beispielsweise durch den Kreis mit dem Bezugszeichen 101. Zumindest bei der heutigen Herstellungstechnik empfiehlt es sich, Kontakte nicht direkt von der zweiten Verdrahtungsebene zur besagten aktiven Bereichen zu führen. Wenn also eine Verbindung von der zweiten Ebene zu einem aktiven Bereich hergestellt werden soll, wird der Leiter der zweiten Ebene zuerst durch eine Öffnung in der zweiten Isolierschicht zu einem Leiter der ersten Ebene geführt. Der Leiter der ersten Ebene wird dann mit dem aktiven Bereich durch einen personalisierten Kontakt (ausgefülltes Rechteck) in der ersten Isolierschicht verbunden. In Fig. 2F ist eine solche Verbindung mit dem Bezugszeichen 102 bezeichnet.

Wo ein Leiter der zweiten Ebene mit einem Leiter der ersten Ebene und dieser wiederum mit einem aktiven Bereich verbunden ist und der besagte Leiter der zweiten Ebene direkt über dem aktiven Bereich liegt, ist der Leiter der zweiten Ebene, beispielsweise der Leiter mit dem Bezugszeichen 103, durch eine schräge Linie dargestellt. Die schräge Linie dient jedoch nur der klaren Darstellung, in Wirklichkeit liegt der Leiter der zweiten Ebene direkt über dem Leiter der ersten Ebene und ist mit diesem über eine Öffnung in der zweiten Isolierschicht verbunden. Der Leiter der ersten Ebene wiederum ist mit dem aktiven Bereich durch einen personalisierten Kontakt direkt unter dem genannten Leiter der zweiten Ebene verbunden. In Fig. 2F, wo ein Leiter der zweiten Ebene lediglich einen personalisierten Kontakt der ersten Ebene kreuzt (keine elektrische Verbindung zwischen der zweiten Ebene und dem Kontakt der ersten Ebene, trennt die zweite Isolierschicht die beiden Leiter. Das Bezugszeichen 104 bezeichnet diesen Strukturteil.

Die erste Isolierschicht 31 (Fig. 2D) kann beispielsweise eine aus Siliciumdioxyd und Siliciumnitrid zusammengesetzte Schicht sein, jedoch auch aus jedem anderen Material bestehen. Zum Aufbau der Isolierschicht 31 sind zahlreiche Verfahren bekannt, wie beispielsweise die Photolithographie, mit der im richtigen Abstand und der richtigen Lage Kontaktöffnungen in der Schicht 31 gebildet werden können, um die gewünschten aktiven Bereiche freizulegen (Kontakte zu Widerstandsbereichen, Emitter-, Kollektor- und Basisbereichen der Transistoren, Halbleiteroberflächenbereiche zur Herstellung der Schottky-Dioden usw.). Die Öffnungen in der Ersten Isolierschicht zu den aktiven Bereichen werden als leitende Kontakte oder personalisierte Kontakte durch Metallisierungsprozesse gebildet, mit denen auch die Metallisierung der ersten Ebene erfolgt. Da zahlreiche Prozesse zur Metallisierung bekannt sind, werden sie nicht näher beschrieben. Für die Metallisierung der ersten Ebene (Ohm'sche Kontakte zu den Transistoren und zu den Widerständen sowie für die nicht Ohm'schen Kontakte der Schottky-Dioden kann beispielsweise eine erste Chromschicht mit 0,1 Micron Dicke, eine zweite Platinschicht mit 0,1 Micron Dicke und darauf eine Aluminiumschicht (oder eine Legierung aus Aluminium und Kupfer) mit 1,0 Micron Dicke niedergeschlagen werden.

Die Herstellung von Schottky-Dioden ist bekannt. Der Schottky-Kontakt enthält eine dünne Schicht aus Tantal und darüber eine dünne Schicht Chrom und Aluminium. Das Aluminium bildet die erste Verdrahtungsebene und kann in bekannter Maskierungs und Ätztechnik bearbeitet werden.

Nachem die erste Verdrahtungsebene gebildet ist, wird eine Isolierschicht 34 (Fig. 2B) beispielsweise aus Quarz oder einem anderen Material zu Isolierung zu zweiten Verdrahtungsebene niedergeschlagen, die auf der ersten Verdrahtungsebene auszubilden ist. Die zweite Verdrahtungsebene kann aus Aluminium oder einem anderen geeigneten Metall oder einer Metallegierung bestehen, wie sie hinreichend bekannt sind. Die zweite Metallschicht kann in derselben oder einer ähnlichen Technik aufgetragen werden, wie die erste Schicht. Wo Leiter der zweiten Ebene mit Leitern der ersten Ebene verbunden werden sollen, werden in der zweiten Isolierschicht in bekannter Technik Öffnungen angebracht, die einen vorgegebenen Teil des darunterliegenden Leiters der ersten Ebene freilegen. Beim Aufbringen der Leiter der zweiten Ebene werden diese Offnungen mit Metall gefüllt, um entsprechende elektrische Verbindungen zwischen bestimmten Leitern der zweiten Ebene und bestimmten Leitern der ersten Ebene herzustellen.

Wo Verbindungen zwischen Leitern der ersten Ebene und aktiven Bereichen hergestellt werden sollen, werden in bekannter Technik in der ersten Isolierschicht Kontaktöffnungen vorgesehen. Diese Kontaktöffnungen liegen einen vorbestimmten Teil des darunterliegenden aktiven Bereiches auf der Halbleiteroberfläche frei. Beim Aufbringen der Leiter der ersten Ebene werden diese Kontaktöffnungen mit Metall gefüllt und so entsprechende personalisierte Kontakte zwischen vorgegebenen Leitern der ersten Ebene und dem darunterliegenden aktiven Halbleiterbereich geschaffen.

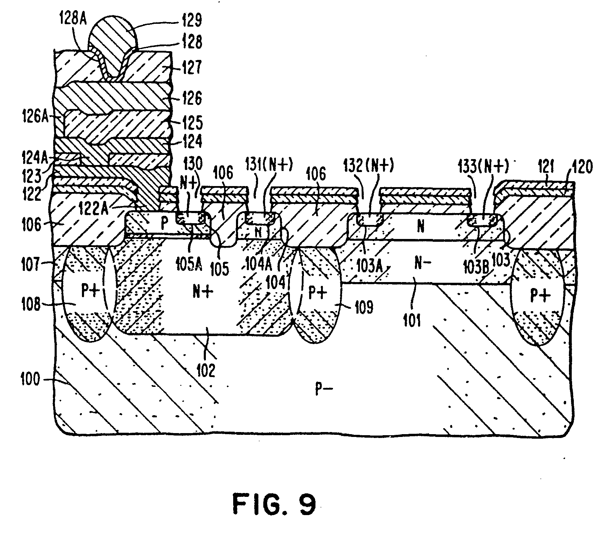

Fig. 9 zeigt einen Querschnitt einer hoch integrierten Schaltung auf einem Siliciumchip mit einer Epitaxieschicht, dotierten Bereichen, den vier Verdrahtungsebenen, einem personalisierten Kontakt, zwei Öffnungen, einem Kontakt und den dazwischen leigenden Isolierschichten des ausgewählten Teiles der integrierten Schaltung. Das P-Substrat 100 hat eine N-Epitaxieschicht 101 und einen N+ Subkollektor 102. Die N-Epitaxieschicht 101 hat einen N+ Bereich 103, einen N-Bereich 104 und einen P-Bereich 105. Die Bereiche 103, 104 und 105 haben voneinander einen Abstand in der Größenordnung der Dicke der Epitaxieschicht und sind durch die vertiefte Oxydisolation (ROI) 106 voneinander elektrisch isoliert. Die P+ Isolationsbereiche 108 und 109 isolieren den N+ Subkollektorbereich 102 von den N-Bereichen 107 und 101. Die Bereiche 104 und 105 sind voneinander durch den Oxydisolationsbereich 106 isoliert. Der N+ Bereich 103 ist in die Epitaxieschicht eingebracht und durch die P+ Isolation vom Subkollektor 102 getrennt. Die Siliciumnitridschicht 120 liegt über dem vertieften Oxydisolationsbereich 106. Die pyrolytische Oxydschicht (SiO$_2$) 121 liegt über der Siliciumnitridschicht 120. In der Nitridschicht 120 und der Oxydschicht 121 liegen Entsprechende Kontaktöffnungen 130, 131, 132 und 133, die aktive Halbleiterbereiche 105A, 104A, 103A und 103B freilegen. Der Leiter 122, der eine Teil der ersten Ebene ist, liegt auf einer ersten Isolierschicht, die aus der Siliciumnitridschicht 120 und der Siliciumdioxydschicht 121 zusammengesetzt ist. Mit dem Leiter 122 ist der personalisierte Kontakt 122A integriert ausgebildet, der den Leiter mit dem aktiven Halbleiterbereich 105 verbindet. Unter einem personalisierten Kontakt wird hier eine Kontaktöffnung verstanden, die durch Füllen mit einem leitenden Metall oder einer Legierung leitend gemacht wurde. Die Personalisierung von Kontakten ist ein wesentlicher Teil des Erfindungsgemäßen Verfahrens zur Herstellung einer Hochintegrierten Halbleiterschaltung und zur Erzielung der verdichteten Verdrahtung und Halbleiterstruktur notwendig. Die zweite Isolierschicht 123 liegt über der ersten Verdrahtungsebene 122. Der Leiter 124, der ein Teil der zweiten Ebene ist, wird durch eine zweite Isolierschicht 123 getragen, die in bekannter Weise aus einem geeigneten Material gebildet werden kann. Die zweite Isolierschicht besteht vorzugsweise aus Siliciumdioxyd. Die Durchgangsöffnung 124A verbindet elektrisch den Leiter 124 der zweiten Ebene mit dem Leiter 122 der ersten Ebene. Der Leiter 126 ist ein Teil der dritten Ebene, die von einer dritten Isolierschicht 125 getragen wird, die über der zweiten Ebene liegt. Die Öffnung 126A verbindet elektrisch den Leiter 126 der dritten Ebene mit dem Leiter 124 der zweiten Ebene. Eine vierte Isolierschicht 127 liegt über der dritten Ebene. Eine vierte Ebene ist als Einzelkontakt oder Verbindung 129 dargestellt. Die Metallisierung der vierten Ebene enthält mehrere Kontakte, von denen nur der Kontakt 129 in der Schnittansicht der Fig. 9 dargestellt ist. Der Kontakt 129 einschließlich der Kontaktbegrenzungsschicht 128 ist durch eine Öffnung 128A in der Schicht 127 mit dem Leiter 126 der dritten Ebene verbunden.

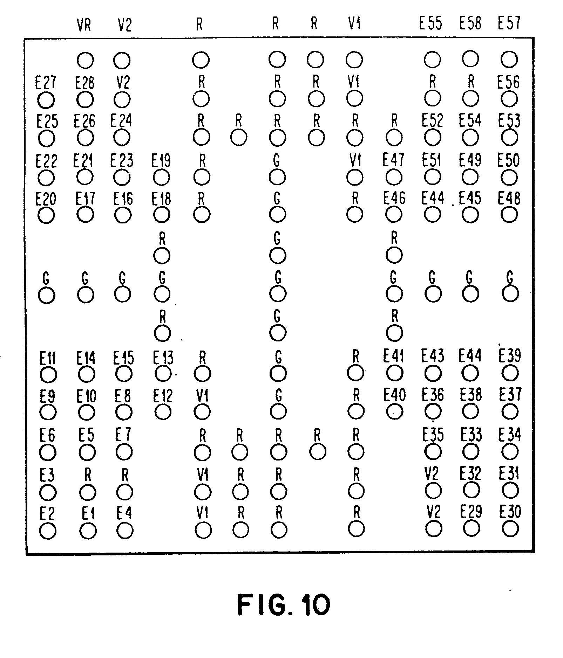

Fig. 10 zeigt eine vergrößerte Draufsicht auf die vierte Verdrahtungsebene des vollständig erfindungsgemäß hergestellten Halbleiteranordnung. Die vierte Ebene besteht aus 124 Kontakten, die dazu dienen, aktive Bereiche vorgegebener Zellen des Halbleiterchips der Fig. 1 über Leiter in der dritten, zweiten und ersten Verdrahtungsebene und personalisierte Kontakte zu verbinden. (Ein solcher Kontakt 129 ist in Fig. 9 gezeigt). Die 58 Kontakte mit den Bezugszeichen E1, E2, . . . , E58 können "EA-Kontakte für Treiber/Empfängersignal" genannt werden und stehen für den elektrischen Anschluß an verdrahtete Treiberschaltungen der Zellen E1 bis E58 oder verdrahtete Empfängerzellen zur Verfügung. Die sechs Kontakte mit dem Bezugszeichen V1 können "EA-Stromanschlußkontakte" genannt werden und dienen dazu, ein erstes Potential z.B. +1,7 Volt, an verdrahtete Zellen des Chips anzulegen. Die vier Kontakte mit dem Bezugszeichen V2 können ebenfalls "EA-Stromanschlußkontakte" genannt werden und dienen dazu, ein zweites Potential, z.B. +5 Volt, an verdrahtete Zellen des Chips anzulegen. Die 37 Kontakte mit dem Bezugszeichen R können "EA-Empfangssignalanschlüsse" genannt werden und dienen dazu die elektrische Verbindung mit verdrahteten Empfangszellen des Chips herzustellen. Die Kontakte mit dem Bezugszeichen VR können "EA-Spannungsregler/Empfängerkontakt" genannt werden und dienen der elektrische Verbindung mit der verdrahteten Spannungsreglerzelle VR des Chips. Wenn der Kontakt VR nicht für die elektrische Verbindung der Zelle VR benutzt wird, kann er auch für die elektrische Verbindung einer oder mehreren Empfängerzellen verwendet werden. Zusammenfassend kann also gesagt werden, die vierte Ebene eine Gruppe von Kontakten vorzugsweise aus Blei/Zinn oder einem gleichwertigen Material umfaßt, die auf dem Chip vorhandene Verdrahtungsebenen (1, 2 oder 3) zur elektrischen Verbindung der integrierten Schaltung und der externen Schaltung benutzen.

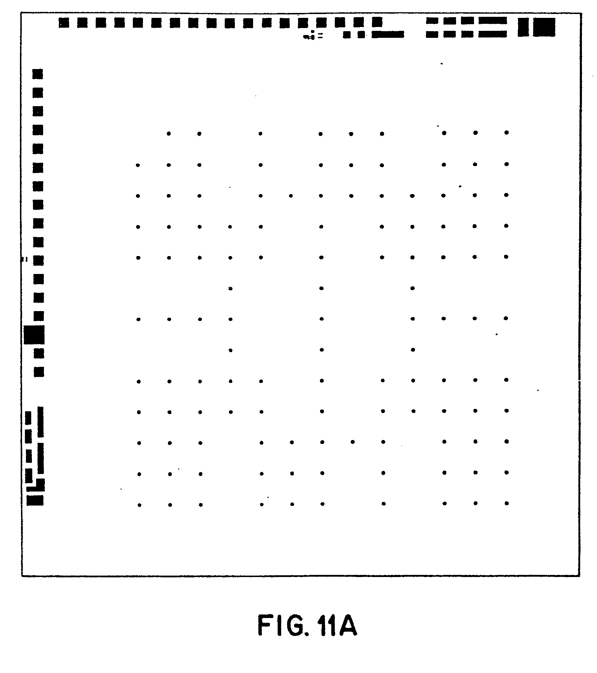

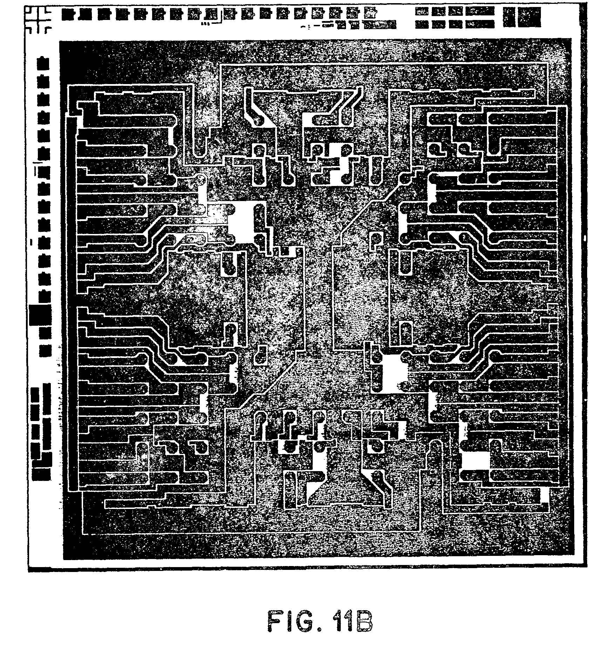

Fig. 11A zeigt eine Draufsicht auf eine Maske zur Herstellung der Öffnungen in der vierten Isolierschicht 127 in Fig. 9. Die in Fig. 11A gezeigte Anordnung der Öffnungen entspricht der Anordnung der Kontakte in Fig. 10. Aus Fig. 9 ist zu ersehen, daß jeder Kontakt der Fig. 10 auf einer Öffnung liegt (Fig. 11A) und durch sie hindurch mit einem Leiter der dritten Verdrahtungsebene in Verbindung steht. In Fig. 9 ist nur ein Kontakt 129 dargestellt, der durch eine Öffnung. in der vierten Isolierschicht 127 zu einem Leiter 126 der dritten Ebene führt.

Fig. 11B zeigt eine Draufsicht auf eine Maske, die für die Leiter der dritten Ebene verwendet wird. Die drunklen Bereiche in Fig. 11B zeigen die Leiter der dritten Ebene. Aus den Fig. 10, 11A und 11B geht hervor, daß die Kontakte mit vorbestimmten Leitern der dritten Ebene verbunden sind. Bestimmte Leiter dieser Ebene sind gemeinsam mit mehr als einem Kontakt der Fig. 10 verbunden. Bestimmte Erdleiter der dritten Ebene sind z.B. an mehrere Massekontakte G angeschlossen. Ebenso sind bestimmte Stromversorgungsanschlüsse V1 bzw. V2 gemeinsam an einen Leiter der dritten Ebene angeschlossen.

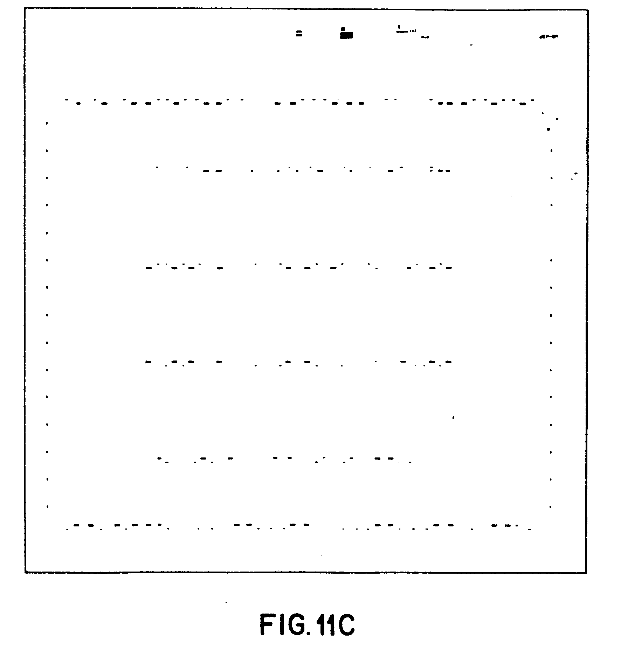

Fig. 11C zeigt eine Draufsicht auf eine Maske für die Herstellung der Öffnungen in der dritten Isolierschicht 125 in Fig. 9. Die in der Maske der Fig. 11C gezeigten Öffnungen verbinden nach der Füllung mit Metall elektrisch vorbestimmte Leiter oder Signalanschlußkontakte der zweiten Ebene mit vorgegebenen Leitern der dritten Ebene.

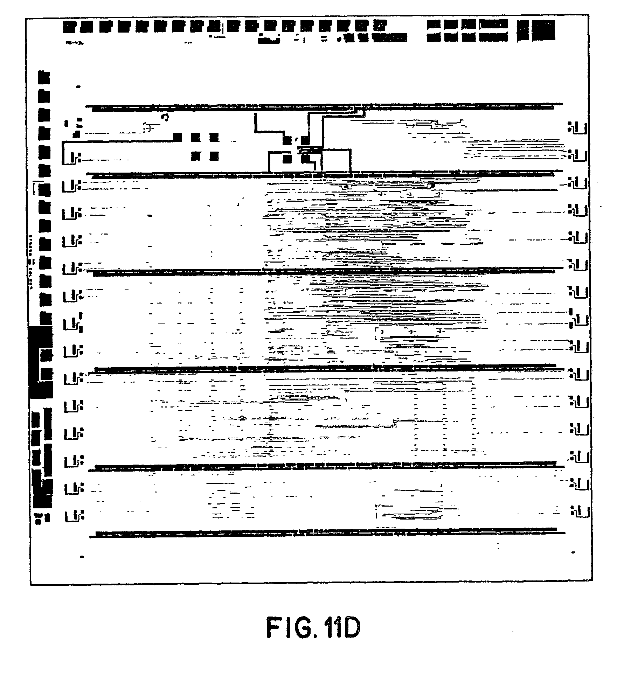

Fig. 11D zeigt eine Draufsicht einer Maske zur Ausbildung der Leiter der zweiten Ebene. Diese Maske ist insofern repräsentativ, als jede herzustellende Teilenummer eine definierte Maske braucht. Die Maske für die Verdrahtung der zweiten Ebene einer ersten Teilenummer liefert z.B. ein anderes Verdrahtungsmuster als die Maske für die Verdrahtung der zweiten Ebene einer zweiten Teilenummer. Zugegebenermaßen besteht eine Ähnlichkeit in den Masken insofern, als die Leitungsmuster Für die Spannungsversorgung und die Masseleitungen gleich oder sehr ähnlich sind. Die auf jeder Maske gezeigte Verdrahtung innerhalb der Zelle entspricht jedoch der für die herzustellende Teilenummer notwendigen Verdrahtung innerhalb der Zelle und insofern wird die in Fig. 11D gezeigte Maske als repräsentativ für die Verdrahtung der zweiten Ebene angesehen.

Fig. 11E zeigt eine Draufsicht einer Maske für die Herstellung der Öffnungen in der zweiten Isolierschicht 123, Fig. 9. Auch diese Maske wird insofern als repräsentativ angesehen, als jede herzustellende Teilenummer eine definierte Maske für die Öffnungen verlangt. Nach der Füllung mit Metall bilden die in der in Fig. 11E gezeigten Maske angebrachten Öffnungen die elektrische Verbindung von bestimmten Leitern der ersten Ebene zu bestimmten Leitern der zweiten Ebene.

Fig. 11E zeigt eine Draufsicht einer Maske für die Herstellung der Leiter der ersten Ebene. Auch diese Maske ist insofern repräsentativ, als die Verdrahtung innerhalb der Zellen und zwischen den Zellen sich von einer Teilenummer zur andern ändert. Alle Masken für die Verdrahtung der ersten Ebene der Verschiedenen Teilenummern sind bezogen auf die Masseleitung und die Versorgungsspannungsleitung identisch. Diese Leitungen sind in Fig. 11F als dicker ausgezogene vertikale Linien dargestellt. Die Verdrahtung zwischen den Zellen und innerhalb der Zelle ist in der in Fig. 11F gezeigten Maske dünner ausgezogen und die häufiger unterbrochenen Linien ändern sich wesentlich von einer Teilenummer zur andern.

Fig. 11G zeigt eine Draufsicht einer Maske zur Herstellung der Öffnungen in der ersten Isolierschicht 120, 121 in Fig. 9. Auch diese Maske ist insofern repräsentativ, als das Muster der Öffnungen in der ersten Isolierschicht sich wesentlich von einer Teilenummer zur andern ändert. Das Muster der Öffnungen in der ersten Isolierschicht für jede Teilenummer richtet sich nach den für die gewünschte Teilenummer zu personalisierenden Kontakten.

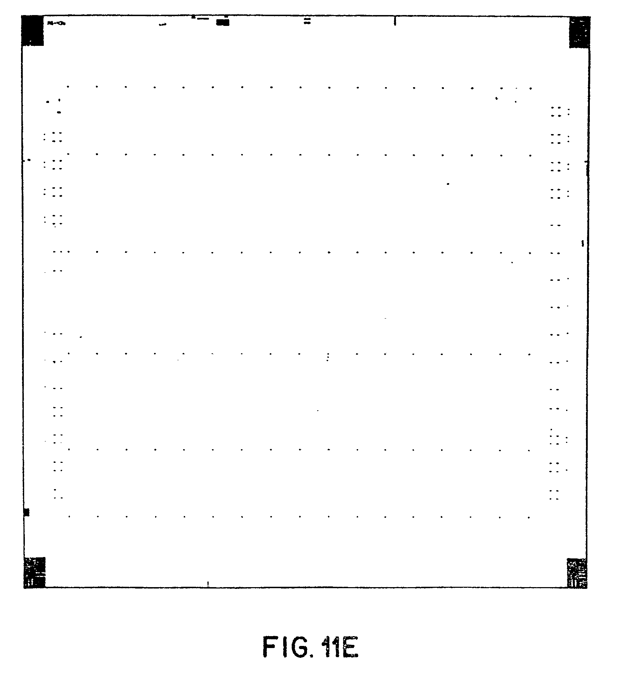

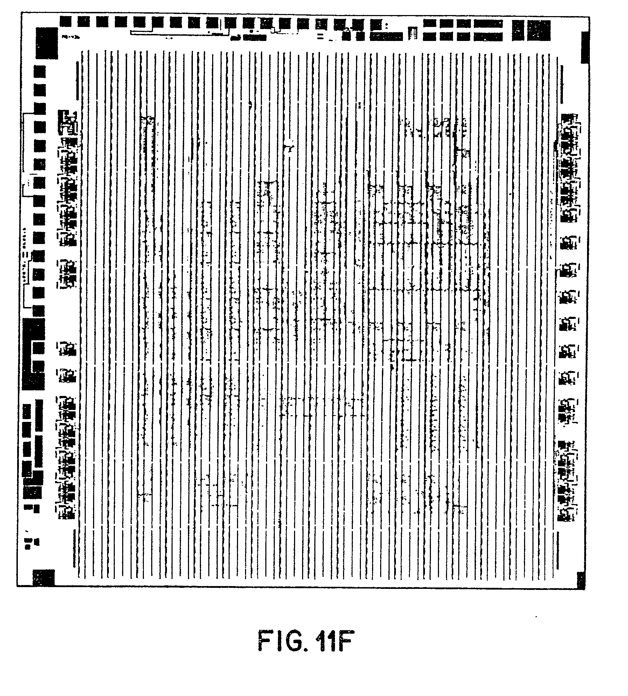

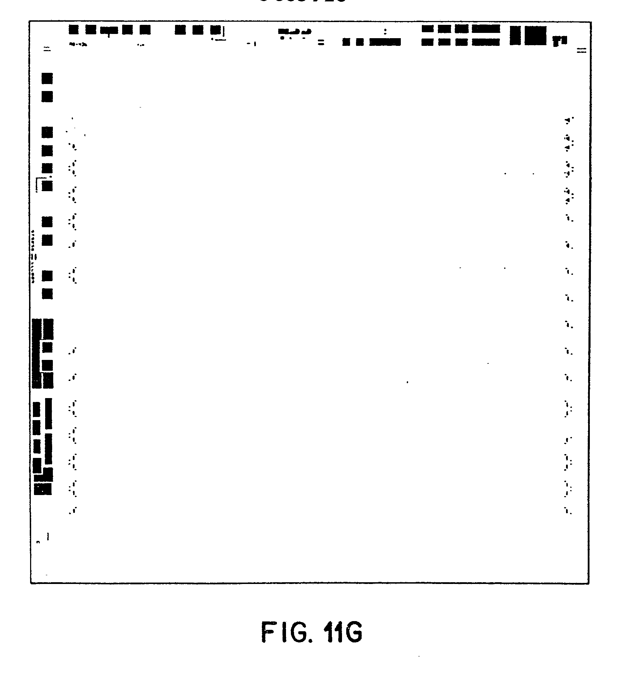

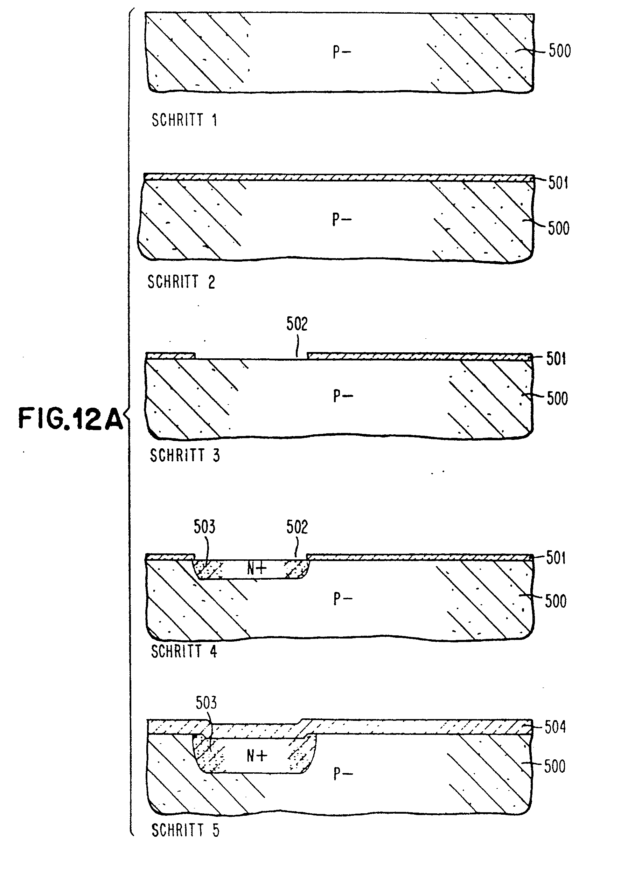

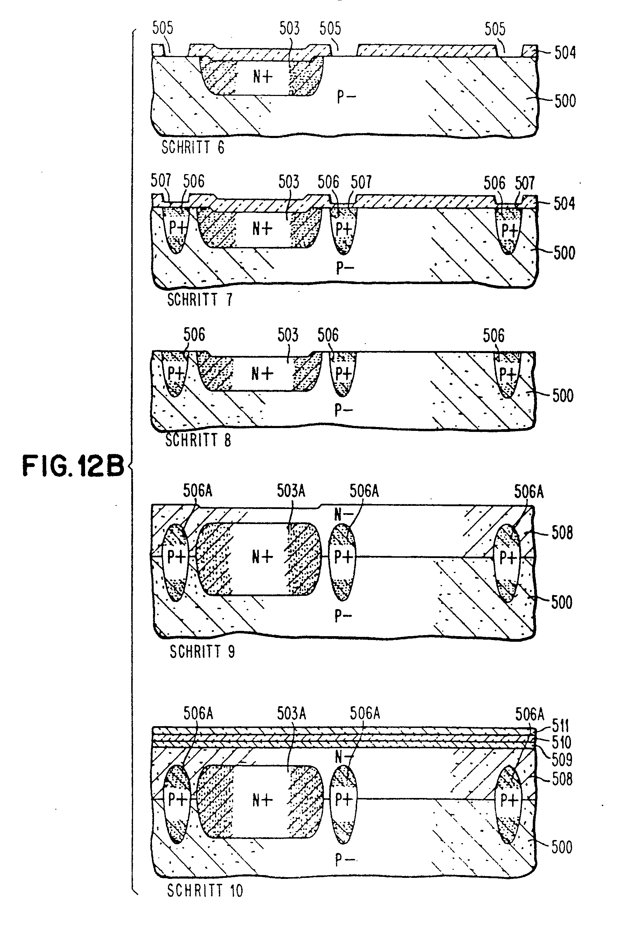

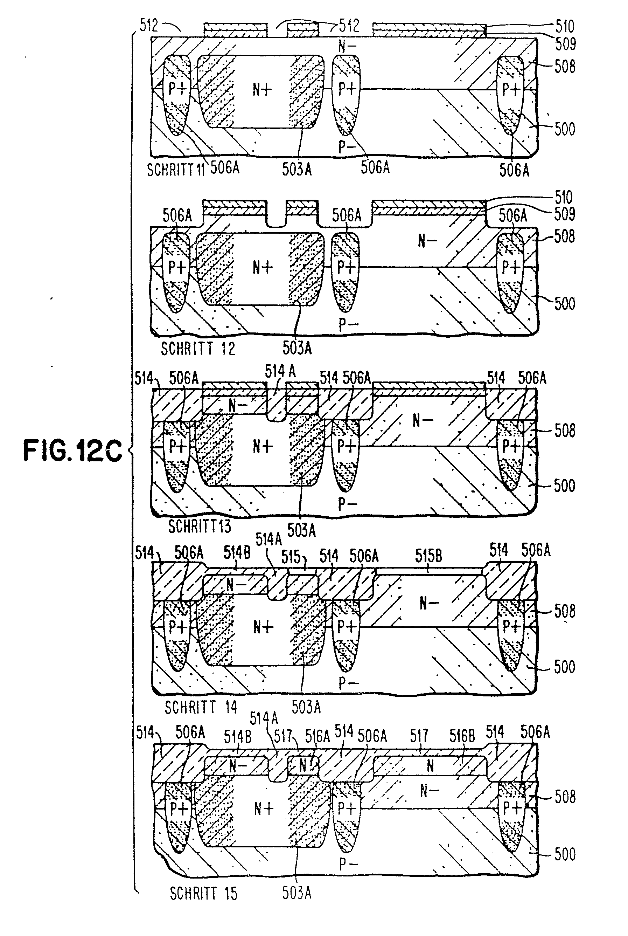

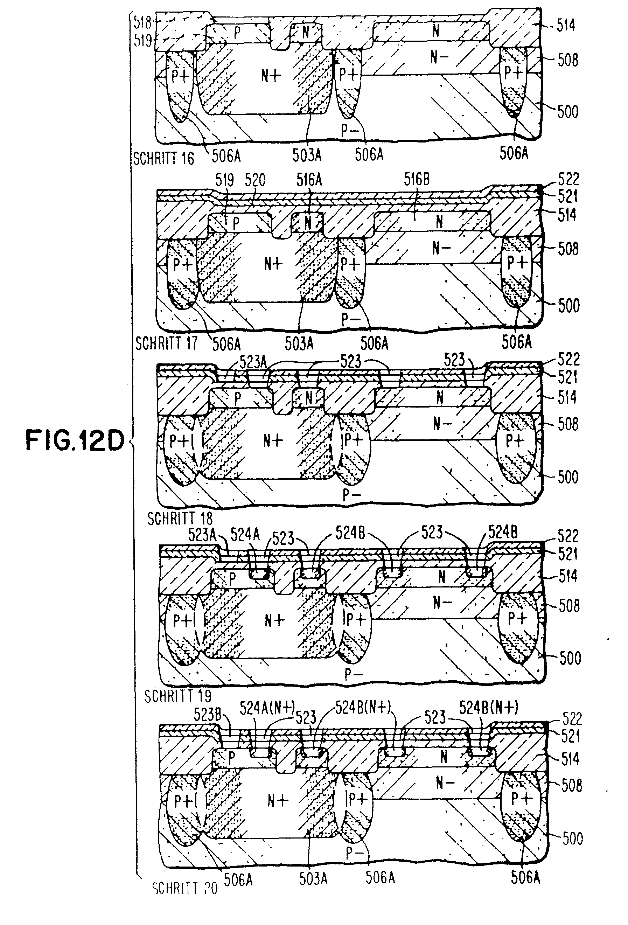

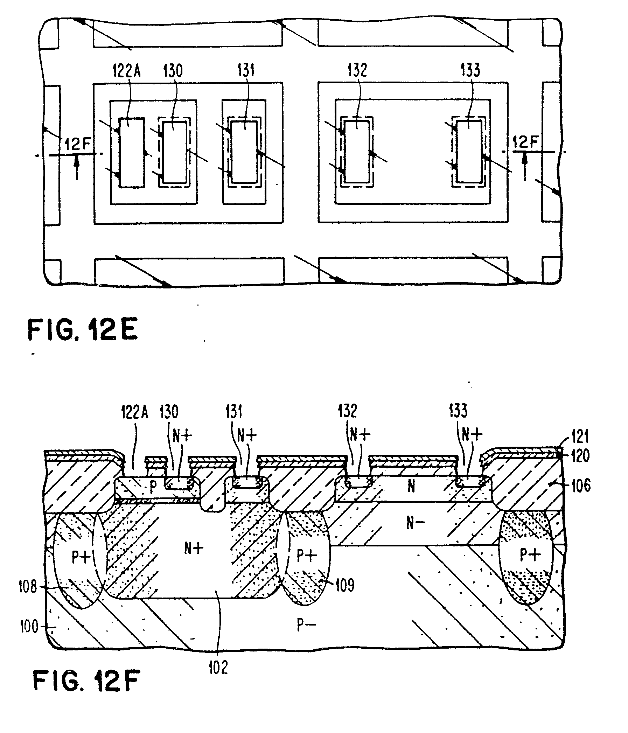

In Zusammenhang mit den Fign. 12A, 12B, 12C und 12D werden die Grundschritte des erfindungsgemäßen Verfahrens zur Herstellung hochintegrierter Schaltungen beschrieben. Dabei werden allgemein bekannte Routineschritte, wie etwa das Reinigen der Oberfläche des Halbleiterwafers usw., nicht ausdrücklich erwähnt. Dasselbe gilt für die Photolithographietechnik, besondere verwendete Atzmittel, die Ätztechnik, die Diffusionstechnik und die Bildung von Oxydschichten, da diese an sich im einzelnen hinreichend bekannt sind.

Die Verbesserung im erfindungsgemäßen Verfahren liegt bei den Prozeßschritten in der sogenannten Personalisierungsebene. Die Reihenfolge und spezifische Art der Ausführung dieser Schritte bei der Herstellung haben im wesentlichen das Ziel, bestimmte hochintegrierte Schaltungen (Teilenummern) und eine sehr hohe Packungs- und Verdrahtungsdichte auf dem Halbleiterchip zu erreichen.

Im Schritt 1, dargestellt in Fig. 12A, wird ein Halbleitersubstrat (Wafer) 500 mit P- Dotierung vorgesehen.

Im Schritt 2 in Fig. 12A wird über der gesamten planaren Oberfläche des Halbleitersubstrates 500 eine Diffusionsmaske 501 gebildet. Diese Subkollektor-Diffusionsmaske besteht vorzugsweise aus einer Schicht thermisch gewachsenen Siliciumdioxyds. Anstelle des Siliciumdioxyds kann natürlich auch ein anderes bekanntes Material verwendet werden.

Im Schritt 3 in Fig. 12A wird ein Fenster 502 in der Diffusionsmaske 501 gebildet. In der Zeichnung ist der Einfachheit halber nur ein kleiner Teil des Substrates und nur ein Fenster für die Subkollektordiffusion gezeigt, in der Praxis befinden sich in der Diffusionsmaske 501 jedoch tausende derartiger Fenster. Durch die Fenster 502 werden N+ Verunreinigungen in die Halbleiterfläche diffundiert. Die Fenster 502 werden bekanntlich durch Photolithographie und chemische Ätzung hergestellt.

In dem in Fig. 12A gezeigten Schritt 4 ist ein N+ Subkollektorbereich 503 gezeigt, der durch Diffusion von N+ Verunreinigungen durch die Fenster 502 der Maske 501 in die freigelegte Oberfläche des Substrates 500 entsteht.

In dem in Fig. 12A gezeigten Schritt 5 wird eine Schicht aus Siliciumdioxyd 504 in bekannten Thermoprozessen aufgewachsen. Diese Oxydschicht 504 bedeckt die ganze planare Oberfläche des Substrates 500 einschließlich aller Öffnungen über den diffundierten Subkollektorbereichen 503.

Im Schritt 6 in Fig. 12B sind die Fenster 505 in der Oxydschicht 504 dargestellt, die durch Verwendung einer Isolationsdiffusionsmaske gebildet werden. Die Maske enthält ein Muster von Öffnungen 505, das den für eine Zellenstruktur gemäß der Darstellung in Fig. 1 gewünschten Isolationsbereichen entspricht. Die in bekannter Photolithographie und Ätztechnik erzeugten Fenster 505 legen die Oberfläche des Halbleitersubstrates 500 frei. Im Bereich des Fensters werden die Isolationsbereiche eindiffundiert.

Im Schritt 7 in Fig. 12B sind die diffundierten Isolationsbereiche 506 dargestellt, die mit P+ Dotierungsmittel, vorzugsweise mit Bor, dotiert sind. In den Fenstern 505 wird während dieses Schrittes eine dünne Oxydschicht 507 gebildet.

Im Schritt 8 in Fig. 12B ist gezeigt, wie die Oxydschicht 504 mit den Teilen 507 von der Oberfläche des Substrates 500 entfernt wird, so daß diese mit den Subkollektorbereichen 503 und den Isolationsbereichen 506 freigelegt wird.

Schritt 9 in Fig. 12B zeigt eine N- Epitaxieschicht 508, die auf der freiliegenden planaren Oberfläche des Substrates 500 aufgewachsen und mit einem N- Dotierungsmittel zu einem spezifischen Widerstand von 0,3 Ohm-cm dotiert wird. Die Dicke dieser Epitaxieschicht beträgt vorzugsweise 2 Micron.

Während des Thermoschrittes für die Epitaxieschicht sind die N+ Subkollektorbereiche 503 in die Epitaxieschicht ausdiffundiert. Die ausdiffundierten Bereiche des Subkollektors sind mit 503A bezeichnet. Auch die P+ Isolationsbereiche 506 sind in die Epitaxieschicht ausdiffundiert und mit 506A bezeichnet.

Im Schritt 10 der Fig. 12B ist dargestellt, wie eine Schicht aus Siliciumdioxyd 509, aus Siliciumnitrid 510 und aus pyrolytischem Siliciumoxyd 511 in der angegebenen Reihenfolge über der freiliegenden Fläche der Epitaxieschicht gebildet werden. Die Siliciumoxydschicht 509 wird auf bekannter Weise thermisch aufgewachsen. Die Siliciumnitridschicht 510 und die pyrolytische Siliciumoxydschicht 511 werden auf bekannte Weise niedergeschlagen oder aufgesprüht.

Im Schritt 11 in Fig. 12C sind Fenster 512 in den Isolierschichten gezeigt, die während des Schrittes 10 gebildet wurden. Die Fenster 512 legen die Oberfläche der Epitaxieschicht 508 frei und werden mit einer sogenannten abgesenkten Oxydmaske in gekannter photolithographischer Ätztechnik gebildet.

Im Schritt 12 in Fig. 12C ist gezeigt, daß Teile der Epitaxieschicht 508 in den durch die Maskenfenster 512 definierten Bereichen weggeätzt werden. Diese weggeätzen Bereiche sind so tief, daß die zu bildenden vertieften Oxydschichten eine Dicke von etwa 1 Micron haben und im wesentlichen mit der freigelegten Oberfläche des Substrates bündig sind.

Schritt 13 in Fig. 12C zeigt das thermische Aufwachsen der vertieften Oxydschicht in den weggeätzten Bereichen der Epitaxieschicht 508. Diese vertieften Oxydschichten sind mit 514 und 514A bezeichnet. Die vertieften Oxydschichten 514 reichen bis zu den P+ diffundierten Isolationsbereichen 506 und vervollständigen die Isolation zwischen den verschiedenen Elementen des Halbleitersubstrats. Die vertieften Oxydschichten 514A isolieren entsprechend zwei Transistorbereiche (d.h. Basisbereich und Kollektoranschlußbereich). Diese beiden Bereiche werden in den nachfolgenden Schritten vervollständigt.

Schritt 14 in Fig. 12C zeigt, daß die Siliciumnitridschicht 510 von der freiliegenden Fläche des Substrates oder Wafers entfernt wird. Der übrige Teil der Siliciumoxydschicht 509 wird jetz als integrierter Teil der vertieften Oxydschicht 514 gezeigt. Diese Teile der verbleibenden Oxydschicht 509 sind mit dem Bezugszeichen 514B bezeichnet. Außerdem sind im Schritt 14 die Fenster 515A und 515B gezeigt, die durch Benutzung einer Maske für die N- Diffusion für einen Widerstand und eine Kollektoranschlußbereiche und bekannte Photolithographische Ätzprozesse geöffnet werden.

Schritt 15 in Fig. 12C zeigt, daß die N- Bereiche 516A und 516B durch Diffusion von N-Dotierungsmaterial (vorzugsweise Phosphor, $POCl_3$) durch die Fenster 515A und 515B gebildet werden. Die Bereiche 516A sind Kollektoranschlußbereiche, die Bereiche 516B werden als Widerstände benutzt. Über den Bereichen 516A und 516B wird außerdem eine dünne Siliciumdioxydschicht 517 thermisch aufgewachsen.

Im Schritt 16 in Fig. 12D wird ein Fenster 518 über dem auszubildenden Basisbereich des Transistors gezeigt. Das Fenster 518 wird mit einer Basisdiffusionsmaske und bekannten photolithographischen Ätzprozessen hergestellt. In einem bekannten Diffusionsprozeß wird der Basisbereich 519 der Transistoren durch Diffundieren eines P-Dotierungsmittels (vorzugsweise Bor, $BBr_3$) durch die Fenster 518 der Maske gebildet.

Schritt 17 der Fig. 12D zeigt, daß das Fenster 518 über dem Basisbereich 519 durch eine thermisch aufgewachsene Siliciumoxydschicht 520 bedeckt ist. Auf der planaren Oberfläche des Substrates werden außerdem eine Schicht aus Siliciumnitrid 521 und eine Schicht aus pyrolytischem Siliciumoxyd 522 in der angegebenen Reihenfolge auf bekannte Weise niedergeschlagen oder aufgesprüht.

Der Schritt 17 des Herstellungsverfahrens ist der letzte Schritt außerhalb der Personalisierung.

Die nachfolgenden Schritte 18 bis 20 sind personalisierte Schritte und unterscheiden sich von den vorhergehenden dadurch, daß die Masken von einer Teilenummer zur anderen in diesen Schritten verschieden sind, wogegen die Masken für die Herstellungsschritte außerhalb der Personalisierung für alle Teilenummern gleich sind.

Die Personalisierung des Master-Slice ergibt sich aus dem sogenannten "physikalischen Entwurf" einer bestimmten Teilenummer. Darunter versteht man die Anordnung oder Auswahl aller Schaltungseinheitszellen, auf dem in Fig. 1 gezeigten Master-Slice, die zur vollständigen Ausführung der vorgegebenen, durch die Teilenummer festgelegten logischen Funktion gebraucht werden. Alle verwendeten Einheitszellen werden durch die Metallmuster der ersten und zweiten Verdrahtungsebene miteinander verbunden. Der physikalische Entwurf (Bestimmung bestimmter zu benutzender Schlatungszellen, ihrer Lage und ihrer Verdrahtung auf dem Master-Slice) erfolgt entweder von Hand oder automatisch unter Anwendung eines computergestützten physikalischen Entwurfssystems. Derartige Systeme, die mit einem Computersystem mit gespeichertem Programm arbeiten, können vielerlei Funktionen ausführen und sind in Fachkreisen allgemein bekannt.

Die Schritte 18 bis 20 sind personalisierte Schritte, in denen elektrische Kontakte zu den Schaltelementen und verschiedenen Bereichen der ausgewählten Zellen eines jeden Master-Slice hergestellt werden. Diese elektrischen Kontakte nennt man personalisierte Kontakte. Durch Anwendung der Technik personalisierter Kontakte läßt sich für das physikalische Entwurfssystems ein beträchtlicher Freiheitsgrad erzielen, durch den man sehr hohe Schaltungsdichte und Verdrahtungsdichte erreicht.

Schritt 18 in Fig. 12D zeigt alle Kontaktöffnungen, die während des physikalischen Entwurfs einer gegebenen Teilenummer gebraucht werden. Mit einer Kontaktierungsmaske werden die gewünschten Öffnungen 523 in der Siliciumnitridschicht 521 und die Öffnungen 523A in der Siliciumoxydschicht 522 vorgesehen. Mit einer anderen N+ Kontaktierungsmaske werden die Oxydschichten 517 (Schritt 15) und 520 (Schritt 17) in der Öffnung 523 weggeätzt. Die Oxydschicht 520 wird jedoch in den Öffnungen 523A nicht weggeätzt, weil diese durch die N+ Kontaktierungsmaske gesperrt sind. Beide Masken werden während des physikalischen Entwurfs personalisiert. Die Darstellung des Schrittes 18 in Fig. 12D zeigt die personalisierten Kontakte für die Schottky-Dioden, wie sie im hochintegrierten STL Master-Slice verwendet werden, nicht im einzelnen. Die Bereiche D1, D3, D5 und D6 in Fig. 2D zeigen jedoch die personalisierten Kontakte durch die erste Isolierschicht 31 für Schottky-Dioden, die für eine STL Teilenummer personalisiert sind. Außerdem ist in Fig. 11G eine Maske für alle gewählten Kontakte gezeigt. Diese Maske wird für eine STL-Teilenummer personalisiert, die personalisierte Kontakte für die Schottky-Dioden enthält.

Weitere einzelne Schritte zur Ausbildung von Schottky-Dioden sind in der Literatur beschrieben.

Schritt 19 in Fig. 12D zeigt, daß ein N+ Dotierungsmittel (vorzugsweise Arsen) durch die Öffnungen 523 im bekannten Emitter-Diffusionsverfahren in die Halbleiteroberfläche diffundiert wird. Diese N+ diffundierten Bereiche sind mit 524A und 524B bezeichnet. Die Bereiche 524A sind die Emitterbereiche der Transistoren und die Bereiche 524B werden hinterher zur Bildung von niederohmigen Anschlüssen zu verschiedenen Schaltelementen benutzt. In den nachfolgenden Schritten werden nämlich ohm'sche Kontakte, personalisierte Kontakte, zur ersten Verdrahtungsebene gebildet. Die N+ Diffusionsmaske wird ebenfalls während des physikalischen Entwurfsprozesses personalisiert.

Schritt 20 in Fig. 12D zeigt die Öffnungen 523B, die mit einer Kontaktierungsmaske und in bekannter photolithographischer Ätztechnik geöffnet werden.

Schritt 20 in Fig. 12D und Fig. 12F zeigen die Schnittansichten eines kleinen Teiles des hochintegrierten Halblieterchips, das schematisch in Fig. 1 dargestellt ist. Fig. 12E ist eine Draufsicht des in Fig. 12F gezeigten Teiles. Die Schnittansicht der Fig. 12F verläuft entlang der Linie 12F—12F in Fig. 12E. Die Fign. 12E und 12F zeigen nur einen Transistor und einen N-Widerstand. Die Struktur ist dargestellt im Endzustand des Schrittes 20 des Herstellungsprozesses. Eine solche Kombination eines Transistors und eines Widerstandes wird in den in den Fign. 4, 5 und 6 gezeigten Schaltungen verwendet. Fig. 2D zeigt einen Querschnitt des internen Transistors und der zugehörigen personalisierten Schottky-Dioden.

Die übrigen Schritte des Herstellungsverfahrens werden im Zusammenhang mit den Fign. 9 und 11A bis 11F beschrieben.

Im Schritt 21, dargestellt in Fig. 9, wird das Muster der ersten Verdrahtungsebene 122 über den ersten Isolationsschichten 120 und 121 auf bekannte Weise durch Verdampfen und chemische Ätzung ausgebildet. Das Metall der ersten Ebene wird vorzugsweise aus einer Kombination aus Aluminium Kupfer und Silicium gebildet. Die erste Verdrahtungsebene wird während des physikalischen Entwurfs personalisiert. Fig. 11F zeigt die zur Ausbildung der spezifischen Verdrahtung der personalisierten ertsten Ebene für eine bestimmte Teilenummer verwendete Maske.

Im Schritt 22 in Fig. 9 werden eine zweite Isolierschicht 123 über der ersten Verdrahtungsebene 122 und die Durchgangsöffnungen 124A auf bekannte Weise durch Niederschlag, Photolithographie und chemische Ätzung ausgebildet. Zum Öffnen der Durchgangsöffnungen 124A wird eine Maske verwendet, die ebenfalls während des physikalischen Entwurfs personalisiert wird. In Fig. 11E ist diese Maske für eine bestimmte Teilenummer gezeigt.

Im Schritt 23 in Fig. 9 wird eine Metallschicht der zweiten Verdrahtungsebene 124 über der zweiten Isolierschicht 123 ausgebildet und mit einer Maske personalisiert. Fig. 11D zeigt diese Maske für eine bestimmte Teilenummer.

Im Schritt 24 in Fig. 9 wird eine dritte Isolierschicht 125 über der zweiten Metallschicht 124 ausgebildet. Die Durchgangsöffnungen 126A zur zweiten Ebene werden auf bekannte Weise durch Niederschlag und photolithographischen Ätzprozess geöffnet. Die Lage der Durchgangslöcher zur zweiten Ebene wird beim Entwurf des hochintegrierten Master-Slice bestimmt und ändert sich für die einzelnen Teilenummern nicht. Fig. 11C zeigt die zur Herstellung der Durchgangsöffnungen 126A in der dritten Isolierschicht verwendete Maske für eine bestimmte Teilenummer.

Im Schritt 25 in Fig. 9 wird eine Metallschicht für die dritten Verdrahtungsebene 126 über der dritten Isolierschicht 125 mit einer Maske in bekannter Technik durch Niederschlag und photolithographischen Ätzprozess gebildet. Die dritte Verdrahtungsebene wird beim Entwurf des Master-Slice festgelegt und ändert sich für die einzelnen Teilenummern nicht. Fig. 11B zeigt die Maske der dritten Verdrahtungsebene.

Im Schritt 26 in Fig. 9 wird eine vierte Isolationsschicht 127 (Glas) über der dritten Verdrahtungsebene 126 ausgebildet. Die Anschlußöffnungen 128A werden auf bekannte Weise durch Niederschlag und photolithographischen Ätzprozess geöffnet. Eine entsprechende Maske ist in Fig. 11A dargestellt.

Im Schritt 27 in Fig. 9 werden eine Schicht 128 zur Kontaktbegrenzung (vorzugsweise eine Kombination aus Cr, Cu, Au, Chrom, Kupfer, Gold) und die Kontakte 129 über der vierten Isolierschicht 127 ausgebildet.

Damit ist die elektrische Verbindung zwischen dem hochintegrierten Master-Slice und den externen Schaltkreisen hergestellt.

**Patentansprüche**

1. Hochintegrierte Halbleiterschaltung basierend auf dem Master-Slice-Prinzip mit in einem Halbleiterchip (1; 100) integrierten, gegeneinander isolierten und in einer Matrix mit 0 bis m Spalten (C) angeordneten Zellen unterschiedlichen Typs (Fig. 1), die über mehrere Verdrahtungsebenen (122, 124, 126, 129 in Fig. 9) entsprechend einer vorgegebenen Funktion verbunden sind, dadurch gekennzeichnet, daß die Spalten 1 bis m — 1 nur Zellen eines ersten (F1, F2, F3, F4) und zweiten Typs (in R11 und R94 der Fig. 1), die Spalte 0 wenigstens eine Zelle eines dritten Typs (VR) und mehrere Zellen eines vierten Typs (E) und die Spalte m ausschließlich mehrere Zellen des vierten Typs (E) enthalten und daß die Oberfläche des Halbleiterchips (1; 100) im wesentlichen vollständig für die Bildung der genannten Zellen des ersten, zweiten, dritten und vierten Typs ausgenutzt wird.

2. Hochintegrierte Halbleiterschaltung nach Patentanspruch 1, dadurch gekennzeichnet, daß die Spalten 1 bis m — 1 jeweils n Zellen in n Zeilen enthalten.

3. Hochintegrierte Halbleiterschaltung nach Patentanspruch 2, dadurch gekennzeichnet, daß einige der genannten n Zeilen der Spalten 1 bis m — 1 ausschließlich Zellen des zweiten Typs enthalten.

4. Hochintegrierte Halbleiterschaltung nach Patentanspruch 3, dadurch gekennzeichnet, daß die übrigen Zeilen der Spalten 1 bis m — 1 ausschließlich Zellen des ersten Typs (F1, F2, F3, F4) enthalten.

5. Hochintegrierte Halbleiterschaltung nach einem der Ansprüche 1 bis 4, dadurch gekennzeichnet, daß Zellen des ersten Typs (F1, F2, F3, F4) in mehreren wiederholten Bündeln von vier gleichen Zellen angeordnet sind und jede Zelle eines jeden Bündels eine eindeutige geometrische Orientierung zu den anderen drei Zellen in diesem Bündel hat (Fig. 2A).

6. Hochintegrierte Halbleiterschaltung nach einem der Ansprüche 1 bis 5, dadurch gekennzeichnet, daß Zellen des zweiten Typs (in R11 und R94 der Fig. 1) in mehreren wiederholten Bündeln von je zwei gleichen Zellen angeordnet sind und jede dieser Zellen eine eindeutige geometrische Orientierung zur anderen Zelle in dem betreffenden Bündel hat (Fig. 3).

7. Hochintegrierte Halbleiterschaltung nach einem der Ansprüche 1 bis 6 dadurch gekennzeichnet, daß die Zellen des ersten Typs zu Schottky-Transistor Logikschaltungen (Fig. 7, 8, 8B), die Zellen des zweiten Typs zu Schottky-Diodenschaltungen (Fig. 3), die Zellen des vierten Typs zu Treiberschaltungen (Fig. 5 und 6) und die Zellen des dritten Typs zu Spannungsreglern (Fig. 4) personalisiert sind.

8. Hochintegrierte Halbleiterschaltung nach einem der Ansprüche 1 bis 7, dadurch gekennzeichnet, daß jede der Spalten 1 bis m — 1 bezüglich Zelleninhalt identisch ist und die Zellen der Spalten 1, 3, 5,...m Spiegelbilder der Zellen in den Spalten 2, 4, 6,...m — 1 sind.

9. Verfahren zur Herstellung einer hochintegrierten Halbleiterschaltung nach einem der Ansprüche 1 bis 8, gekennzeichnet durch:

(a) Bildung einer ersten Isolierschicht (120, 121; 520, 521) auf der gesamten Oberfläche des Halbleiterchips, in dem die Zellen integriert sind (Schritt 17 in Fig. 12D);

(b) Bestimmung der Zellen, die zur Bildung der Halbleiterschaltung herangezogen werden sollen, aufgrund einer vorgegebenen Funktion bzw. Teilenummer einer solchen Schaltung;

(c) Freilegung eines vorgegebenen Musters von Kontaktöffnungen in der ersten Isolierschicht (120, 121) entsprechend den benötigten Zellenkontaktbereichen der für die hochgradig integrierte Schaltung entsprechend der ersten Teilenummer benutzten Zelle (Fig. 11G);

(d) Bildung eines vorgegebenen Musters von Leitern und Kontakten in Kontaktöffnungen als erste Verdrahtungsebene (122 in Fig. 9) über der ersten Isolierschicht (120, 121), die jede der genannten Kontaktöffnungen in dem vorgegebenen Muster von Kontaktöffnungen personalisiert und eine Verbindung zwischen den Zellen und wenigstens teilweise innerhalb der Zellen liefert, die für die Benutzung zur hochgradig integrierten Halbleiterschaltung entsprechend der genannten ersten Teilenummer ausgewählt wurden, wodurch nur bestimmte Kontakte der benutzten Zellen personalisiert werden (Fig. 11F);

(e) Bildung einer zweiten Isolierschicht (123) über der ersten Verdrahtungsebene (122) und den freiliegenden Teilen der ersten Isolierschicht (121, 120);

(f) Freilegung eines vorgegebenen Musters von Öffnungen in der zweiten Isolierschicht (123), die den gewünschten Verbindungen (124A) von bestimmten Leitern der ersten Verdrahtungsebene (122) und Leitern der nachträglich noch zu bildenden zweiten Verdrahtungsebene (124) entsprechen (Fig. 11E);

(g) Ausbildung eines vorgegebenen Musters von Leitern und Leitungsdurchführungen in den Öffnungen der zweiten Isolierschicht (123) als zweite Verdrahtungsebene (124) über der zweiten Isolierschicht, wobei die zweite Verdrahtungsebene die Verbindung innerhalb der Zellen liefert und die erste Verdrahtungsebene in vorgegebener Weise mit der zweiten Verdrahtungsebene verbunden ist (Fig. 11D);

(h) Bildung einer dritten Isolierschicht (125) über der zweiten Verdrahtungsebene (124) und den freiliegenden Teilen der genannten zweiten Isolierschicht (123);

(i) Freilegung eines vorgegebenen Musters von Öffnungen (126A) in der dritten Isolierschicht (125), das den gewünschten Verbindungen von Leitern der zweiten (124) und der dritten Verdrahtungsebene (126) entspricht, die noch zu bilden ist (Fig. 11C);

(j) Bildung eines vorgegebenen Musters von Leitern und Leitungsdurchführungen in den Öffnungen der genannten dritten Isolierschicht als dritte Verdrahtungsebene (126) über der dritten Isolierschicht (125), wodurch die dritte Verdrahtungsebene in vorgegebener Weise mit den Leitern der zweiten Verdrahtungsebene (124) verbunden wird (Fig. 11B);

(k) Bildung einer vierten Isolierschicht (124) über der dritten Verdrahtungsebene (126) und den freiliegenden Teilen der dritten Isolierschicht (127);

(l) Bildung eines vorgegebenen Musters von Öffnungen (128A) in der vierten Isolierschicht (127) derart, daß sie einen darunterliegenden Teil eines Leiters der genannten dritten Verdrahtungsebene (126) freiliegen (Fig. 11A) und

(m) Ausbildung von Kontakten (129) in Öffnungen (128A) der vierten Isolierschicht (127) zur elektrischen Kontaktierung der darunterliegenden Leiter der dritten Verdrahtungsebene (126), wobei über diese Kontakte gleichzeitig der Anschluß zu externen Schaltungen erfolgt (Fig. 10).

10. Verfahren nach Anspruch 9, dadurch gekennzeichnet, daß im Schritt (d) wenigstens bestimmte Kontaktöffnungen für Schottky-Dioden Kontakte mit darunterliegenden Zellenbereichen personalisiert werden und die übrigen Kontaktöffnungen so personalisiert werden, daß sie ohm'sche Kontakte mit den darunterliegenden Zellenbereichen bilden (Schritt 18—20 in Fig. 12D).

**Claims**

1. A large scale integrated semiconductor circuit based on the masterslice technique with cells of different types (Fig. 1) which are integrated in a semiconductor chip (1; 100) and are electrically isolated from each other, said cells, arranged in an array of unit cells with 0 to m columns (C), being connected by several levels of metallization (122, 124, 126, 129, Fig. 9) according to a given function, characterized in that the columns 1 to m − 1 contain only cells of a first type (F1, F2, F3, F4) and a second type (in R11 and R94 of Fig. 1), column 0 contains at least one cell of a third type (VR) and a plurality of cells of a fourth type (E), and column m contains exclusively a plurality of cells of the fourth type (E), and that the surface of the semiconductor chip (1; 100) is substantially utilized to form said cells of the first, second, third and fourth types.

2. The large scale integrated semiconductor circuit according to patent claim 1, characterized in that the columns 1 to m − 1 each contain n cells in n rows.

3. The large scale integrated semiconductor circuit according to patent claim 2, characterized in that certain of the columns 1 to m − 1 with n rows contain exclusively cells of the second type.

4. The large scale integrated semiconductor circuit according to patent claim 3, characterized in that the remaining rows of columns 1 to m − 1 contain exclusively cells of the first type (F1, F2, F3, F4).

5. The large scale integrated semiconductor circuit according to any one of the claims 1 to 4, characterized in that the cells of the first type (F1, F2, F3, F4) are arranged in a plurality of repetitive clusters of four like cells and each cell of each cluster has a unique geometric orientation with respect to the remaining three like cells contained in its cluster (Fig. 2A).

6. The large scale integrated semiconductor circuit according to any one of the claims 1 to 5, characterized in that the cells of the second type (in R11 and R94 of Fig. 1) are arranged in a plurality of repetitive clusters of two like cells and each cell of each cluster of two like cells has a unique geometric orientation with respect to the remaining one cell contained in its cluster (Fig. 3).

7. The large scale integrated semiconductor circuit according to any one of the claims 1 to 6, characterized in that the cells of the first type are personalized to provide Schottky transistor logic circuits (Figs. 7, 8, 8B), the cells of the second type are personalized to provide Schottky diode circuits (Fig. 3), the cells of the fourth type are personalized to provide driver circuits (Figs. 5 and 6), and the cells of the third type are personalized to provide voltage regulators (Fig. 4).

8. The large scale integrated semiconductor circuit according to any one of the claims 1 to 7. characterized in that the contents of the columns 1 to m − 1 are identical with each other and the cells of columns 1, 3, 5, ... are m mirror images of the cells in columns 2, 4, 6, ... m − 1.

9. A method of fabricating a large scale integrated semiconductor circuit according to any one of the claims 1 to 8, comprising the following steps:

(a) forming a first insulating layer (120, 121; 520, 521) over the entire semiconductor chip surface in which the cells are integrated (step 17 in Fig. 12D);

(b) determining respectively in accordance with a predetermined function and a part number of such a circuit, which ones of the plurality of unit cells are to be utilized to provide the large scale integrated semiconductor circuit;

(c) opening a predetermined pattern of contact openings in the first insulating layer (120, 121), the predetermined pattern of contact openings being strictly in accordance with the required cell contact regions of the cells to be utilized to provide the large scale integrated semiconductor circuit in accordance with the first part number (Fig. 11G);

(d) forming a predetermined pattern of conductors and conductive contacts in the contact openings as a first level of metallization (122 in Fig. 9) over the first insulating layer (120, 121), where the first level of metallization personalizes each of the contact openings of the predetermined pattern of contact openings and provides intracell and at least partial intercell wiring of the cells selected to be utilized to provide the large scale integrated semiconductor circuit in accordance with said first part number, whereby only the utilized cells have at least certain of their contacts personalized (Fig. 11F);

(e) forming a second insulating layer (123) over the first level of metallization (122) and the exposed portions of the first insulating layer (121, 120);

(f) opening a predetermined pattern of via holes in the second insulating layer (123), the predetermined pattern of via holes in the second insulating layer being strictly in accordance with the desired interconnection (124A) of certain conductors of the first level of metallization (122) and conductors of a second level of metallization (124) to be formed hereinafter (Fig. 11E);

(g) forming a predetermined pattern of conductors and conductive vias in the via openings of the second insulating layer (123) as a second level of metallization (124) over the second insulating layer, where the second level of metallization provides intercell wiring and whereby the first level of metallization is interconnected in a predetermined manner with the second level of metallization (Fig. 11D);

(h) forming a third insulating layer (125) over the second level of metallization (124) and the exposed portions of said second insulating layer (123);

(i) forming a predetermined pattern of via holes (126A) in the third insulating layer (125), the predetermined pattern of via holes in the third insulating layer being strictly in accordance with the desired interconnection of the conductors of the second level (124) and conductors of a third level of metallization (126) to be formed hereinafter (Fig. 11C);

(j) forming a predetermined pattern of conductors and conductive vias in the via openings of said third insulating layer as a third level of metallization (126) over the third insulating layer (125), whereby the third level of metallization is interconnected in a predetermined manner with the conductors of the second level of metallization (124) (Fig. 11B);

(k) forming a fourth insulating layer (124) over the third level of metallization (126) and the exposed portions of the third insulating layer (127);

(l) forming a predetermined pattern of via holes (128A) in the fourth insulating layer (127), where each of the via holes exposes an underlying portion of a conductor of said third level of metallization (126) (Fig. 11A), and

(m) forming conductive pads (129) in the via holes (128A) of the fourth insulating layer (127) for electrically contacting the underlying conductors of the third level of metallization (126), whereby said pads serve as an electrical interface between the large scale integrated semiconductor circuit and circuitry external to said circuit (Fig. 10).

10. The method according to claim 9, characterized in that in step (d) at least certain ones of the contact openings are personalized to provide Schottky diode contacts with the underlying cell regions and the remaining ones of the contact openings are personalized to provide ohmic contacts with the underlying cell regions (steps 18 to 20 in Fig. 12D).

## Revendications

1. Circuit semi-conducteur à haute densité d'intégration basé sur le principe de la tranche mère (master slice) qui comporte des cellules de différents types (figure 1) qui sont intégrées dans une microplaquette semi-conductrice (1; 100), isolées les unes des autres, et arrangées dans une matrice comportant de 0 à m colonnes (C), lesdites cellules étant inter-connectées à travers plusieurs niveaux de câblage (122, 124, 126, 129, figure 9) selon une fonction prédéterminé, caractérisé en ce que les colonnes 1 à m — 1 contiennent seulement des cellules d'un premier type (F1, F2, F3, F4) et d'un second type (en R11 et R94 de la figure 1), en ce que la colonne 0 contient au moins une cellule d'un troisième type (VR) et plusiers cellules d'un quatrième type (E), en ce que la colonne m contient exclusivement plusiers cellules du quatrième type (E), et en ce que la surface de la microplaquette semiconductrice (1; 100) est essentiellement utilisée pour former lesdites cellules des premier, second, troisième et quatrième types.

2. Circuit semi-conducteur à haute densité d'intégration selon la revendication 1, caractérisé en ce que les colonnes 1 à m — 1 contiennent chacune n cellules dans n rangées.

3. Circuit semi-conducteur à haute densité d'intégration selon la revendication 2, caractérisé en ce quelques unes des rangées n précitées des colonnes 1 à m — 1 contiennent exclusivement des cellules du second type.

4. Circuit semi-conducteur à haute densité d'intégration selon la revendication 3, caractérisé en ce que le reste des rangées des colonnes 1 à m — 1 contient exclusivement des cellules du premier type (F1, F2, F3, F4).

5. Circuit semi-conducteur à haute densité d'intégration selon l'une des revendications 1 à 4, caractérisé en ce que les cellules du premier type (F1, F2, F3, F4) sont arrangées en plusieurs groupes répétés de quatre cellules identiques et en ce que chaque cellule de chaque groupe a une orientation géométrique distincte de celles des trois autres cellules de ce groupe (figure 2A).

6. Circuit semi-conducteur à haute densité d'intégration selon l'une des revendications 1 à 5, caractérisé en ce que les cellules du second type (en R11 et R94 de la figure 1) sont arrangées en plusieurs groupes répétés chacun de deux cellules identiques et en ce que chacune de ces cellules a une orientation géométrique distincte par rapport à l'autre cellule de son groupe (figure 3).

7. Circuit semi-conducteur à haute densité d'integration selon l'une des revendications 1 à 6, caractérisé en ce que les cellules du premier type sont personnalisées pour former des circuits du type logique à transistors de Schottky (figures 7, 8, 8B), les cellules du second type pour former des circuits du type logique à diodes de Schottky (figure 3), les cellules du quatrième type pour former des circuits d'attaque ou de commande (figures 5 et 6), et les cellules du troisième type pour former des régulateurs de tension (figure 4).

8. Circuit semi-conducteur à haute densité d'intégration selon l'une des revendications 1 à 7, caractérisé en ce que le contenu des cellules des colonnes 1 à m — 1 est identique et en ce que les cellules des colonnes 1, 3, 5, . . . , m, sont des images inversées (par effet miroir) des cellules dans les colonnes 2, 4, 6, . . . , m — 1.

9. Procédé pour fabriquer un circuit semi-conducteur à haute densité d'intégration selon l'une des revendications 1 à 8, caractérisé par:

a) la formation d'une première couche isolante (120, 121; 520, 521) sur toute la surface de la microplaquette semi-conductrice dans laquelle les cellules sont intégrées (étape 17 de la figure 12D);

b) la détermination des cellules qui sont à utiliser pour former le circuit semi-conducteur selon une fonction ou un numéro de pièce prédéterminé d'un tel circuit,

c) l'exposition d'une configuration prédéterminée d'ouvertures de contact dans la première couche isolante (120, 121), en fonction des régions de contact de cellule nécessaires de la cellule utilisée pour le circuit intégré à haute densité d'intégration selon le premier numéro de pièce (figure 11G);

d) la réalisation d'une configuration prédéterminée de conducteurs et de contacts dans des ouvertures de contact pour former un premier niveau de câblage (122 de la figure 9) au-dessus de la première couche isolante (120, 121), qui personnalise chacune des ouvertures de contact précitées dans la configuration prédéterminée d'ouvertures de contact et établit une connexion entre les cellules et au moins partiellement à l'intérieur des cellules choisies pour être utilisées pour le circuit semi-conducteur à haute densité d'intégration selon le premier numéro de pièce mentionné, ce qui permet de personnaliser seulement certains contacts des cellules utilisées (figure 11F);

e) la formation d'une seconde couche isolante (123) au-dessus du premier niveau de câblage (122) et les parties exposées de la première couche isolante (121, 120);

f) l'exposition d'une configuration prédéterminée d'ouvertures dans la seconde couche isolante (123), qui correspondent aux connexions désirées (124A) de certains conducteurs du premier niveau de câblage (122) et aux conducteurs du second niveau de câblage (124) à réaliser ultérieurement (figure 11E);

g) la formation d'une configuration prédéterminée de conducteurs et de conducteurs de traversée dans les ouvertures de la seconde couche isolante (123) comme second niveau de câblage (124) au-dessus de la seconde couche isolante, le second niveau de câblage fournissant la connexion à l'intérieur des cellules et le premier niveau de câblage étant connecté de la manière prédéterminée au second niveau de câblage (figure 11D);

h) la formation d'une troisième couche isolante (125) au-dessus du second niveau de câblage (124) et des parties exposées de la seconde couche isolante précitée (123);

i) l'exposition d'une configuration prédéterminée d'ouvertures (126A) dans la troisième couche isolante (125), ladite configuration correspondant aux connexions désirées des conducteurs des second et troisième niveaux de câblage (124, 126) qui restent à former (figure 11C);

j) la formation d'une configuration prédéterminée de conducteurs et de traversées conductrices dans les ouvertures de la troisième couche isolante précitée comme troisième niveau de câblage (126) au-dessus de la troisième couche isolante (125), le troisième niveau de câblage étant ainsi connecté de la manière prédéterminée aux conducteurs du second niveau de câblage (124) (figure 11B);

k) la formation d'une quatrième couche isolante (124) au-dessus du troisième niveau de câblage (126) et des parties exposées de la troisième couche isolante (127);

l) la formation d'une configuration prédéterminée d'ouvertures (128A) dans la quatrième couche isolante (127) de telle sorte qu'elle expose une partie sous-jacente d'une conducteur du troisième niveau de câblage précité (126) (figure 11A), et

m) la formation de contacts (129) dans les ouvertures (128A) de la quatrième couche isolante (127) pour établir des contacts électriques des conducteurs sous-jacents du troisième niveau de câblage (126), ces contacts permettant simultanément la connexion aux circuits externes (figure 10).

10. Procédé selon la revendication 9, caractérisé en ce que dans l'étape (d), on personnalise au moins certaines ouvertures de contact pour former des contacts de type Schottky avec les régions de cellules sous-jacentes et en ce qu'on personnalise le reste des ouvertures de contacts de telle sorte qu'elles forment des contacts de type ohmique avec les régions de cellules sous-jacentes (étapes 18 à 20 de la figure 12D).

FIG. 1

F3     F4

+V    F1    +V    F2    +V

**FIG. 2**

| F3 | F4 |
|----|----|
| F1 | F2 |

**FIG. 2A**

F    F

**FIG. 3**

**FIG. 3A**

**FIG. 2C**

**FIG. 2D**

**FIG. 2B**

0 005 723

RB +V RC EINHEITSZELLE

FIG. 2E

FIG. 2F

FIG. 4

FIG. 4A

FIG. 5

FIG. 5A

FIG. 6

FIG. 6A

FIG. 7

FIG. 7A

0 005 723

FIG. 8

FIG. 8A

AUSGÄNGE

FIG. 8B

FIG. 8C

AUSGÄNGE

10

FIG. 9

VR  V2      R       R   R   V1      E55  E58  E57

○ ○   ○   ○ ○ ○     ○ ○ ○
E27 E28 V2   R   R R V1   R R E56
○ ○ ○   ○   ○ ○ ○     ○ ○ ○
E25 E26 E24   R R R R R R E52 E54 E53
○ ○ ○   ○ ○ ○ ○ ○   ○ ○ ○ ○
E22 E21 E23 E19 R   G   V1 E47 E51 E49 E50
○ ○ ○ ○ ○   ○     ○ ○ ○ ○ ○
E20 E17 E16 E18 R   G   R E46 E44 E45 E48
○ ○ ○ ○ ○   ○     ○ ○ ○ ○

R   G   R
○   ○   ○

G G G G   G   G R G G G
○ ○ ○ ○   ○   ○ ○ ○ ○ ○

R   G   R
○   ○   ○

E11 E14 E15 E13 R   G   R E41 E43 E44 E39
○ ○ ○ ○ ○   ○   ○ ○ ○ ○ ○
E9 E10 E8 E12 V1   G   R E40 E36 E38 E37
○ ○ ○ ○ ○   ○   ○ ○ ○ ○ ○
E6 E5 E7   R R R R R E35 E33 E34
○ ○ ○   ○ ○ ○ ○ ○ ○ ○ ○
E3 R R V1 R R R V2 E32 E31
○ ○ ○ ○ ○ ○ ○ ○ ○ ○
E2 E1 E4 V1 R R R V2 E29 E30
○ ○ ○ ○ ○ ○ ○ ○ ○ ○

# FIG. 10

FIG. 11A

FIG. 11B

FIG. 11C

FIG. 11D

FIG. 11E

FIG. 11F

FIG. 11G

FIG.12A

SCHRITT 1

SCHRITT 2

SCHRITT 3

SCHRITT 4

SCHRITT 5

FIG.12B

SCHRITT 6

SCHRITT 7

SCHRITT 8

SCHRITT 9

SCHRITT 10

FIG.12C

SCHRITT 11 506A 503A 506A 506A

SCHRITT 12 506A 503A

SCHRITT 13 503A

SCHRITT 14 503A

SCHRITT 15 503A

FIG.12D

SCHRITT 16

SCHRITT 17

SCHRITT 18

SCHRITT 19

SCHRITT 20

23

FIG. 12E

FIG. 12F